(19) Europäisches Patentamt
European Patent Office
Office européen des brevets

(11) EP 4 707 825 A1

(12) EUROPEAN PATENT APPLICATION

(43) Date of publication:
**11.03.2026 Bulletin 2026/11**

(21) Application number: **24198459.0**

(22) Date of filing: **04.09.2024**

(51) International Patent Classification (IPC):
***G01R 27/20*** *(2006.01)* ***G01R 27/22*** *(2006.01)*
***G01R 31/52*** *(2020.01)* ***B60L 3/00*** *(2019.01)*
***H01M 8/04858*** *(2016.01)*

(52) Cooperative Patent Classification (CPC):
**G01R 27/20; B60L 3/0069; G01R 27/22; G01R 31/52;** H01M 2250/20

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Volvo Truck Corporation**
**405 08 Göteborg (SE)**

(72) Inventors:
- **NEILSON, Rohan**
  **721 31 VÄSTERÅS (SE)**
- **BARKAH, Dani**
  **ESKILSTUNA 632 24 (SE)**

(74) Representative: **Ström & Gulliksson AB**
**P.O. Box 4188**
**203 13 Malmö (SE)**

(54) **COMPUTER SYSTEM AND COMPUTER-IMPLEMENTED METHOD FOR DETERMINING AN ELECTRICAL PROPERTY OF AN ELECTRICALLY CONDUCTING FLUID PATH**

(57) A computer system is provided. The computer system comprises processing circuitry configured to: electrically connect at least one vehicle subsystem (10) to a traction voltage pole (16, 16A, 16B) of a vehicle (1) and to a ground potential (P), said at least one vehicle subsystem (10) comprising at least a first electrically conducting fluid path (20, 21); obtain first isolation resistance data (224) between the traction voltage pole (16, 16A, 16B) and the ground potential (P); electrically shortcircuit a first portion of the first fluid path (20, 21); obtain second isolation resistance data (228) between the traction voltage pole (16, 16A, 16B) and the ground potential (P) when the first portion of the first fluid path (20, 21) is shortcircuited; and determine the electrical resistance of the fluid of the first fluid path (20, 21) of the at least one vehicle subsystem (10) based on the first isolation resistance data (224) and the second isolation resistance data (228).

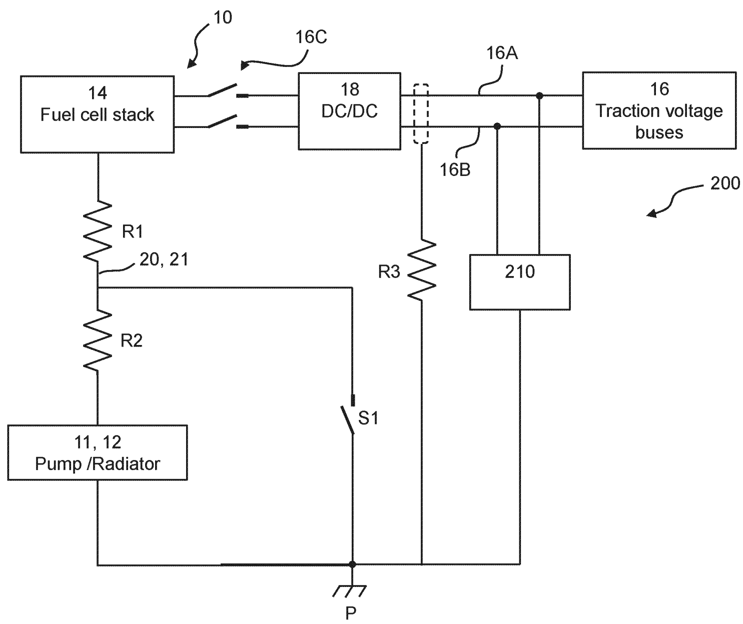


FIG. 2



Processed by Luminess, 75001 PARIS (FR)

# Description

## TECHNICAL FIELD

The disclosure relates generally to electrical systems. In particular aspects, the disclosure relates to a computer system and a computer-implemented method for determining an electrical property of an electrically conducting fluid path. The disclosure can be applied to heavy-duty vehicles, such as trucks, buses, and construction equipment, among other vehicle types. Although the disclosure may be described with respect to a particular vehicle, the disclosure is not restricted to any particular vehicle.

## BACKGROUND

Voltages in modern electrified vehicles present a significant hazard via the potential for exposing people to dangerous electrical currents. Ensuring this hazard will always be safely isolated and contained throughout a long life of the vehicle or during/after a collision is not practical and therefore isolation resistance monitoring systems are employed to monitor the resistance to electrical leakage, thereby allowing systems to be shut down before or when a potential for dangerous current arises.

Isolation resistance measurement systems are typically configured to monitor the resistance to electrical current leakage from the traction voltage poles to the vehicle chassis; usually from an entire voltage bus connecting multiple batteries, inverters etc. Where individual devices and/or sub-systems can be isolated from the main voltage bus their impact on the total value can be assessed but this has proven to come with some limitations. Further, isolation of such devices and/or sub-systems may not be possible during operation of the associated vehicle.

Fuel cell stacks and/or immersion cooled batteries typically require liquid coolant and this coolant is exposed to significant voltages. Electrical conductivity through the coolant can carry potentially dangerous leakage currents or facilitate corrosion or electrolysis, generally forcing the use of specialty low-conductivity coolants. Additionally, ion-exchanging filters are typically required to remove ions which increase the electrical conductivity, and specialty materials and cleaning procedures to minimize the depletion of these filters.

Isolation resistance monitoring systems, which measure the resistance to electrical current leakage between the high voltage buses and chassis, are typically employed in electrified vehicles to ensure that the safety and integrity of the electrical network carrying hazardous voltage is maintained.

These monitoring systems reliably assess the isolation resistance of the complete network connected to them but not the running distribution throughout this network which can provide greater insight and improved diagnostic capabilities.

In the case of electrical leakage through the cooling system, conductivity sensors can provide a measure of the electrical conductivity of the coolant at a specific temperature and ususally distant location.

These sensors can be useful for ensuring the fluid adequately prevents electrolysis and/or corrosion but are expensive, usually need to make/attempt compensations for temperature, are typically quite susceptible to contamination.

Coolant conductivity is inversely proportional to the resistance across it (i.e. the resistivity). This can allow plausibility checks to further monitor and ensure integrity and safety but this requires resolving the individual resistances making up the network.

Where a simple and cost effective solution for resolving resistance elements exists the conductivity can instead be inferred from this and where multiple measures become available cross-checks can improve accuracy and plausibility checks also performed in the absence of conventional conductivity measurement.

In order to reduce cost and achieve a high efficiency, adding an isolation resistance monitoring system which for example measures isolation resistance between a fuel cell stack and a chassis of a vehicle must do so before the fuel cell stack is connected to the traction voltage phases and it cannot continue this measurement once the fuel cell stack is connected and operating. Further, the conductivity in coolant will vary with temperature and the presence of ions will also vary when the system starts.

Wet surfaces within the fuel cell stack system also provide leakage paths while operating which may be very different or insignificant when the system is not running. Drying and other shutdown procedures can produce discrepancies from the operating condition even after shutdown.

In view of above, there is a need for improvement for determining electrical properties of electrical systems, in particular where electrically conducting fluid paths are present.

## SUMMARY

According to a first aspect of the disclosure, a computer system is provided. The computer system comprises processing circuitry configure to: electrically connect at least one vehicle subsystem to a traction voltage pole of a vehicle and to a ground potential, said at least one vehicle subsystem comprising at least a first electrically conducting fluid path; obtain first isolation resistance data between the traction voltage pole and the ground potential; electrically short-circuit a first portion of the first fluid path; obtain second isolation resistance data between the traction voltage pole and the ground potential when the first portion of the first fluid path is short-circuited; and determine the electrical resistance of the fluid of the first fluid path of the at least one vehicle subsystem based on the first isolation resistance data and the second isolation resistance data. The first aspect of the disclosure may seek to improve safety in electrical systems. A technical benefit may include ascertaining the resistance contribution of a targeted leakage path from a total resistance being measured in a network of electrical leakage currents.

Optionally in some examples, including in at least one preferred example, the processing circuitry is further configured to: obtain the geometrical ratio between the first portion of the first fluid path and the entire fluid path; and determine the electrical resistance of the fluid of the fluid path of the at least one vehicle subsystem based on the geometrical ratio. A technical benefit may include removing one degree of freedom resulting in a defined system with a simple solution.

Optionally in some examples, including in at least one preferred example, the processing circuitry is further configured to: determine the conductivity of the fluid of the first fluid path based on the determined electrical resistance. A technical benefit may include removing the need for a dedicated (and expensive) coolant conductivity sensor for obtaining of the conductivity, which is an important factor affecting performance of especially fuel cell systems.

Optionally in some examples, including in at least one preferred example, the at least one vehicle subsystem further comprises a second electrically conducting fluid path. The processing circuitry is further configured to: electrically short-circuit a first portion of the second fluid path; obtain third isolation resistance data between the traction voltage pole and the ground potential when the first portion of the second fluid path is short-circuited; and determine the electrical resistance of the fluid of the second fluid path of the at least one vehicle subsystem based on the first isolation resistance data and the third isolation resistance data. A technical benefit may include reliable and robust monitoring of the electrical resistance of an inlet conduit as well as an outlet conduit of a fuel cell system.

Optionally in some examples, including in at least one preferred example, the processing circuitry is further configured to: obtain the temperature of the fluid of the first and/or second fluid path; and determine a relationship between the electrical conductivity of the fluid of the first and/or second fluid path and temperature. A technical benefit may include a reliable and robust monitoring of the isolation resistance even when this parameter is dependent on the temperature. Further benefits may include i) the possibility to calculate the expected resistance through other non-monitored paths which may be at different temperatures, ii) the possibility to limit operating temperatures, iii) the possibility to find temperature dependency of non-coolant related resistances and leakages, and iv) the possibility to project conductivity at higher temperature, e.g. where local temperatures within the stack or cell modules are expected to be significantly higher than the system coolant outlet temperature thereby contributing bulk of the isolation resistance.

Optionally in some examples, including in at least one preferred example, the processing circuitry is further configured to: obtain the geometrical ratio between the first portion of the first fluid path and the entire fluid path; determine the electrical resistance of the fluid of the fluid path of the at least one vehicle subsystem based on the geometrical ratio; and determine the conductivity of the fluid of the first fluid path based on the determined electrical resistance. The at least one vehicle subsystem further comprises a second electrically conducting fluid path, and the processing circuitry is further configured to: electrically short-circuit a first portion of the second fluid path; obtain third isolation resistance data between the traction voltage pole and the ground potential when the first portion of the second fluid path is short-circuited; and determine the electrical resistance of the fluid of the second fluid path of the at least one vehicle subsystem based on the first isolation resistance data and the third isolation resistance data; obtain the temperature of the fluid of the first and/or second fluid path; and determine a relationship between the electrical conductivity of the fluid of the first and/or second fluid path and temperature; and, check the conductivity of the fluid of the first fluid path at a specific temperature against the conductivity of the fluid of the second fluid path at the same specific temperature.

According to a second aspect of the disclosure, a vehicle is provided. The vehicle comprises the computer system of the first aspect. The second aspect of the disclosure may seek to improve safety in electrical systems of vehicles. A technical benefit may include ascertaining the resistance contribution of a targeted leakage path from a total resistance being measured in a network of electrical leakage currents.

Optionally in some examples, including in at least one preferred example, the vehicle further comprises at least one fuel cell system or an immersion cooled battery system forming the vehicle subsystem. A technical benefit may include a simple and reliable monitoring of the electrical conductivity of the fluid paths of the fuel cell system or battery system.

Optionally in some examples, including in at least one preferred example, the at least one fuel cell system comprises at least one coolant channel preferably connected to a radiator and/or to a pump, and wherein the coolant channel forms at least a first fluid path. A technical benefit may include reliable and safe monitoring of the potential hazard from leakage currents in the coolant channel. While the first fluid path may be connected to a radiator and/or to a pump, in some examples the first fluid path is a bypass channel for example extending from one output coolant channel, via a components such as a charged air cooler, to one input coolant channel. Optionally, the first fluid path is a dead fluid path.

Optionally in some examples, including in at least one preferred example, the vehicle further comprises a first switch configured to short circuit a first portion of the first fluid path. A technical benefit may include using a simple component to allow the isolation resistance to be monitored.

Optionally in some examples, including in at least one preferred example, the vehicle further comprises a second switch configured to short circuit a first portion of the second fluid path. A technical benefit may include using simple components to monitor and determine the isolation resistance in multiple fluid paths.

According to a third aspect of the disclosure, a computer-implemented method is provided. The computer-implemented method comprises electrically connecting, by processing circuitry of a computer system, at least one vehicle subsystem to a traction voltage pole of a vehicle and to a ground potential, said at least one vehicle subsystem comprising at least a first electrically conducting fluid path. The method further comprises obtaining, by the processing circuitry, first isolation resistance data between the traction voltage pole and the ground potential; electrically short-circuiting, by the processing circuitry, a first portion of the first fluid path; obtaining, by the processing circuitry, second isolation resistance data between the traction voltage pole and the ground potential when the first portion of the first fluid path is short-circuited; and determining, by the processing circuitry, the electrical resistance of the fluid of the first fluid path of the at least one vehicle subsystem based on the first isolation resistance data and the second isolation resistance data. The third aspect of the disclosure may seek to improve safety in electrical systems. A technical benefit may include ascertaining the resistance contribution of a targeted leakage path from a total resistance being measured in a network of electrical leakage currents.

Optionally in some examples, including in at least one preferred example, the method further comprises obtaining, by the processing circuitry, the geometrical ratio between the first portion of the first fluid path and the entire fluid path; and determining, by the processing circuitry, the electrical resistance of the fluid of the fluid path of the at least one vehicle subsystem based on the geometrical ratio. A technical benefit may include removing one degree of freedom resulting in a defined system with a simple solution.

Optionally in some examples, including in at least one preferred example, the method further comprises determining, by the processing circuitry, the conductivity of the fluid of the first fluid path based on the determined electrical resistance. A technical benefit may include a fast and reliable obtaining of the conductivity, which is an important factor affecting performance of especially fuel cell systems.

Optionally in some examples, including in at least one preferred example, the at least one vehicle subsystem further comprises a second electrically conducting fluid path. The method further comprises: electrically short-circuiting, by the processing circuitry, a first portion of the second fluid path; obtaining, by the processing circuitry, third isolation resistance data between the traction voltage pole and the ground potential when the first portion of the second fluid path is short-circuited; and determining, by the processing circuitry, the electrical resistance of the fluid of the second fluid path of the at least one vehicle subsystem based on the first isolation resistance data and the third isolation resistance data. A technical benefit may include reliable and robust monitoring of the electrical resistance of a coolant conduit of a fuel cell system or battery system.

Optionally in some examples, including in at least one preferred example, the method further comprises: obtaining, by the processing circuitry, the temperature of the fluid of the first and/or second fluid path; and determining, by the processing circuitry, a relationship between the electrical conductivity of the fluid of the first and/or second fluid path and temperature. A technical benefit may include a reliable and robust monitoring of the isolation resistance even when this parameter is dependent on the temperature.

Optionally in some examples, including in at least one preferred example, the method further comprises: electrically disconnecting, by the processing circuitry, the at least one vehicle subsystem from the traction voltage pole; obtaining, by the processing circuitry, idle isolation resistance data between the traction voltage pole and the ground potential when at least one vehicle subsystem is electrically disconnected from the traction voltage pole; and determining, by the processing circuitry, a faulty ground connection of the at least one vehicle subsystem based on the idle isolation resistance data and the first isolation resistance data. A technical benefit may include a clear identification of a specific ground connection when it is faulty.

According to a fourth aspect of the disclosure, a computer program product is provided. The computer program product comprises program code for performing, when executed by the processing circuitry, the method of the third aspect. The fourth aspect of the disclosure may seek to improve safety in electrical systems of vehicles. A technical benefit may include ascertaining the resistance contribution of a targeted leakage path from a total resistance being measured in a network of electrical leakage currents.

According to a fifth aspect of the disclosure, a non-transitory computer-readable storage medium is provided. The non-transitory computer-readable storage medium comprises instructions, which when executed by the processing circuitry, cause the processing circuitry to perform the method of the third aspect. The fifth aspect of the disclosure may seek to improve safety in electrical systems of vehicles. A technical benefit may include ascertaining the resistance contribution of a targeted leakage path from a total resistance being measured in a network of electrical leakage currents.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

## BRIEF DESCRIPTION OF THE DRAWINGS

Examples are described in more detail below with reference to the appended drawings.

**FIG. 1** is an exemplary side view of a vehicle according to an example.

**FIG. 2** is an exemplary electrical circuit of a fuel cell system according to an example.

**FIG. 3** is an exemplary electrical circuit of a fuel cell system according to an example.

**FIGS. 4A-C** are schematic circuit diagrams illustrating a method for detecting a ground fault according to an example.

**FIG. 5** is an exemplary system diagram of an isolation resistance measurement system according to an example.

**FIGS. 6-8** are schematic flow charts of different parts of an algorithm for isolation resistance measurement of a fuel cell system according to an example.

**FIG. 9** is an exemplary system diagram of an isolation resistance measurement system according to an example.

**FIGS. 10-12** are exemplary electrical circuits of different fuel cell systems according to various examples.

**FIG. 13** is a flow chart of a method of isolation resistance measurement according to an example.

**FIG. 14** is a schematic diagram of an exemplary computer system for implementing examples disclosed herein, according to an example.

## DETAILED DESCRIPTION

The detailed description set forth below provides information and examples of the disclosed technology with sufficient detail to enable those skilled in the art to practice the disclosure.

In the following various examples will be given all related to the general idea of determining the electrical resistance of a fluid path. Isolation resistance data is obtained before and after short-circuiting a portion of the fluid path. By comparing these isolation resistance data, it is possible to determine the electrical resistance of the fluid path. Also, there is a possibility to connect potential to a normally non-polarised area of fluid or alternatively isolating a normally polarized area of fluid.

**FIG. 1** is an exemplary view of a vehicle **1** according to one example. The vehicle **1** comprises at least one isolation resistance monitoring system **200.** The at least one isolation resistance monitoring system **200** is configured to determine the electrical resistance of one or more fluid paths of the vehicle **1,** for example the fluid path forming part of a fuel cell system **10** of a vehicle and extending between a fuel cell stack **14** and a pump **11** and/or a radiator **12.** The vehicle **1** is programmed to control the isolation resistance monitoring system **200,** as will be described further in the following.

The vehicle **1** comprises, at least to some extent, processing circuitry **110** forming part of a computer system **100** (see **FIG. 15**). The processing circuitry **110** is configured to implement the ground fault detection system **200.**

The vehicle **1** may further comprise communications circuitry **90** configured to receive and/or send communications. The communications circuitry **90** may be configured to enable the vehicle **1** to communicate with one or more external devices or systems such as a cloud server **60.** The communication with the external devices or systems may be directly or via a communications interface such as a cellular communications interface **70,** such as a radio base station. The cloud server **60** may be any suitable cloud server exemplified by, but not limited to, Amazon Web Services (AWS), Microsoft Azure, Google Cloud Platform (GCP), IBM Cloud, Oracle Cloud Infrastructure (OCI), DigitalOcean, Vultr, Linode, Alibaba Cloud, Rackspace etc. The communications interface may be a wireless communications interface exemplified by, but not limited to, Wi-Fi, Bluetooth, Zigbee, Z-Wave, LoRa, Sigfox, 2G (GSM, CDMA), 3G (UMTS, CDMA2000), 4G (LTE), 5G (NR) etc. The communication circuitry **90** may, additionally or alternatively, be configured to enable the vehicle **1** to be operatively connected to a Global Navigation Satellite System (GNSS) **80** exemplified by, but not limited to, global positioning system (GPS), Globalnaya Navigatsionnaya Sputnikovaya Sistema (GLONASS), Galileo, BeiDou Navigation Satellite System, Navigation with Indian Constellation (NavIC) etc. The vehicle **1** may for example be configured to utilize data obtain from the GNSS **80** to determine a geographical location of the vehicle **1.**

The vehicle **1** in **FIG. 1** comprises the computer system **100** and the isolation resistance monitoring system **200.** The computer system **100** may be operatively connected to the isolation resistance monitoring system **200** and optionally to the communications circuitry **90** of the vehicle **1.** The computer system **100** comprises processing circuitry **110.** The computer system **100** may comprise a storage device **120,** advantageously a non-volatile storage device such as a hard disk drives (HDDs), solid-state drives (SSDs) etc. In some examples, the storage device **120** is operatively connected to the computer system **100.** The isolation resistance monitoring system **200** may comprise isolation resistance monitoring system processing circuitry **202;** the isolation resistance monitoring system processing circuitry **202** may be part of the processing circuitry **110** of the computer system **100.**

An example of a fuel cell system **10** is shown in **FIG. 2.** The fuel cell system **10** is configured to be monitored by an isolation resistance monitoring system **200,** which in the shown example is at least partly embodied by an isolation resistance monitor device **210.** Optionally, the isolation resistance monitoring system **200** may be internally provided with the fuel cell system 10, then relying on isolation resistance measurements on the main voltage bus once the fuel cell system **10** connects to the bus (whereby the internal isolation resistance monitoring system is disconnected).

The fuel cell system **10** comprises a fuel cell stack **14** which is connectable to traction voltage buses **16** using contactors **16C** via a DC/DC converter **18.** The isolation resistance monitoring device **210** is connected to the traction voltage buses **16** and is configured to measure the resistance across the fuel cell system **10,** i.e. between the traction voltage poles **16A, 16B** and a chassis **P** of a vehicle.

The fuel cell system **10** further comprises a pump **11** and/or a radiator **12.** The pump **11** and/or the radiator **12** are connected to the fuel cell stack **14** by one or more liquid coolant conduits **20, 21** forming one or more fluid paths. Each one of the liquid coolant conduits **20, 21** may be represented by an electrical resistance **R1+R2.** The magnitude of these resistances **R1, R2** is dependent on the electrical conductivity of the coolant flowing inside the conduits **20, 21.** As the electrical conductivity through the coolant can carry potentially dangerous leakage currents, especially if the resistances **R1, R2** are low, the pump **11** and/or the radiator **12** are grounded to the chassis **P.** Hence, the leakage currents can be measured and monitored.

In the shown example of **FIG. 2,** the resistance, illustrated by the combined resistance **of R1** and **R2,** to a grounded component such as the pump **11** or the radiator **12,** is shorted and isolation resistance measurement continues through the component's ground strap. Optionally, resistance **R1** may comprise the resistance both above and below resistance **R2,** whereby resistance **R2** represents a floating section.

Shorting across **R1** or **R2** is preferably accomplished by closing a switch **S1** and such shortening should result in a drop in the measured isolation resistance proportional to the coolant conductivity of the conduit **20, 21** which can then be estimated/calculated. If the isolation resistance is low and shorting across these resistances does not produce a significant drop then coolant conductivity is probably not a problem and replacing the coolant and ion exchange filters should not be necessary. Here, the word "probably" is referring to the switch being broken if no change is seen or the ground may be missing if the drop is lower than expected, or if it disagrees significantly from other locations or sensors values.

If **R3** has a significant resistance and shorting **R1** or **R2** do not produce symmetrical or correctly proportional responses then a grounding fault is indicated at the component **11, 12** producing the lower than expected drop.

If for example the drop due to **R1, R2** is low, shorting **R1** and **R2** simultaneously can be used to get a better reading.

Being a shorting ground connection the fuel cell system **10** should be capable of surviving a significant current but it does not normally see significant current as conventional contactors do (since leakage currents are normally of mA magnitude or lower). Optionally, if the fuel cell system **10** is provided with a fuse that can be blown by potentially dangerous capacitive discharges then it may also be able to indicate these conditions since the fuse should blow and the isolation resistance monitoring system **200** will then start triggering a fault since no change will occur when it fails to short the resistances to ground.

The change in isolation resistance when the fuel cell stack **14** is connected can be used to calculate the isolation resistance of the fuel cell stack **14.** Alternatively the isolation resistance monitoring device **210** can be configured to measure the isolation resistance of the fuel cell stack **14** before it is connected.

By providing switchable grounding points in the coolant, much closer than is normally desired, and which are normally isolated but can be selectively shorted to ground **P** (or normally grounded and breakable) then a simulated fault can be created in the coolant system formed by conduits **20, 21** and the pump **11** and/or radiator **12.** The change in isolation resistance when the fault is made or broken gives an indicator as to the contribution that coolant electrical conductivity is making to the isolation resistance. In particular, if there is no or very little change in isolation resistance this indicates that a ground connection is missing.

The resistance through the shorted fault path, i.e. over closed switch **S1,** can be calculated or estimated from the change in isolation resistance values. This division should then be planned to give a good result without causing problems and known so as to avoid creating unknowns.

Further, if the geometry of the coolant path is known, then the coolant conductivity can be calculated or estimated from the fault path resistance.

In the specific example shown in **FIG. 2,** and especially where conductivity estimation is desired it is advantageous to have onboard isolation measurement performed inside the fuel cell system **10** while it is disconnected from the other systems on the vehicle **1** as this helps to exclude uncertainty and external effects.

Here R3 is the collected resistances to ground via all other paths than the target path R1/R2. The isolation resistance monitoring device normally sees (R1+R2)‖R3, such as:

$$\frac{1}{R_T} = \frac{1}{R_1+R_2} + \frac{1}{R_3}.$$

When S1 closes this reduces to R1||R3, such as: $\frac{1}{R_{S1}} = \frac{1}{R_1} + \frac{1}{R_3}$, thereby providing a system with a degree of freedom:

$$\frac{1}{R_T} - \frac{1}{R_{S1}} = \frac{1}{R_1+R_2} - \frac{1}{R_1}.$$

Where the division is known, say $R_1 = 2{*}R_2$, this becomes solvable for $R_1$, $R_2$ and R3:

$$\frac{1}{R_T} - \frac{1}{R_{S1}} = \frac{1}{(2+1)R_2} - \frac{1}{2R_2}.$$

$$R_2 = \frac{\left(\frac{1}{3} - \frac{1}{2}\right)}{\left(\frac{1}{R_T} - \frac{1}{R_{S1}}\right)}.$$

Where R2 is resistance through a non-conductive pipe with cross sectional area, A and length, L and is full of coolant with conductivity σ:

$$\sigma = \frac{L}{A \times R_2}.$$

The above highlights that the example shown in **FIG. 2** is a simplification since it shows only a single coolant leakage path.

**FIG. 3** shows a further example of a fuel cell system **10,** using two switches **S1, S2,** wherein each switch **S1, S2** is configured to short-circuit a portion of a first fluid path **20** and a second fluid path **21,** respectively. The first fluid path **20,** represented by resistances **R1, R2** may be a conduit connecting the fuel cell stack **14** to a radiator **12,** and the second fluid path **21,** represented by resistances **R3, R4** may be a conduit connecting the fuel cell stack **14** to a pump **11.** The provision of two switches **S1, S2** provides two more states from the one additional switch **S1.** It also may allowing **R2** and **R4** to be a greater proportion of **(R1+R2)** and **(R3+R4)** since switching both switches **S1, S2** can be avoided where the total isolation resistance is prohibitively low.

First **(R3+R4)||R6** can be bundled into a single resistance **(R3** in the example shown in **FIG. 2)** to allow the original solution for **R1, R2** to be performed in the same way. Then **(R1+R2)||R6** can be analyzed in the same way but using switch **S2** instead.

This produces two different coolant conductivity values corresponding to the different temperatures of the inlet and outlet of the fuel cell stack **14,** i.e. in the first and second fluid paths **20, 21.** This can be compared to the temperature dependence observed during warmup and other temperature fluctuations.

**R6** on its own can be calculated from the known **(R1+R2)** and **(R3+R4)** without having to disconnect the running subsystem **10.**

Switching both switches **S1, S2** then produces a fourth state and over-defined system of equations allowing improvement of accuracy and reduction or quantification of uncertainty. If one of the switches **S1, S2** produces no impact then the ground is indicated to be broken and if it produces an unexpected or a disproportionately low impact then a missing ground is indicated.

Calculation using **R1+R5** and/or **R3+R5** using known **R5** geometry and/or proportionality can recover affected measurements until the ground is repaired. Additionally the resistance **R5** may be two different values, one relating to the radiator side and one relating to the pump side. Where the characteristics of resistance **R5** matches or explains the discrepancy in observations this may point to which side the resistance **R5** fault has occurred.

Coolant from a fuel cell system **10** is used as the example but the general concept could be extended to other devices or groups of devices.

Voltage can be measured at selected points rather than (or in combination with) analysis of the isolation resistance itself, in particular where a voltage division is created and/or modified. This has the potential for significantly higher accuracy and certainty compared to assessing changes in total vehicle isolation resistance measurement. This is due to the fact that projection from small changes in a large scale measurement is inherently inaccurate and the isolation resistance measurement is affected by corresponding change in capacitance).

As shown in **FIG. 3,** the radiator **12** has lost its connection to ground **P** (indicated by the dashed line). When a component loses its ground connection through a service error, fatigue, corrosion, collision etc., leakage currents will no longer flow via this path causing the resistance measured by the isolation resistance monitoring device **210** to show an improved condition despite a deterioration in actuality and potential hazard present. Additionally the voltage potential present at the component will generally increase. Hence, missing ground connections can cause a false improvement in the measured isolation resistance since they stop leakage via the affected path causing it to appear to have a high resistance.

This situation presents a potential hazard since the affected radiator **12** may now possess significant voltage potential against the chassis, however, the leakage path is now broken and so the measured isolation resistance for the vehicle actually improves indicating better than usual safety.

Where a low isolation resistance occurs and technicians begin tracing such a fault it is possible that a grounding connection may be broken or removed and not replaced or fixed during the remediation work. As shown above the isolation resistance measurement will actually improve when this mistake is made giving a false positive resolution. Even further, an unfamiliar or unsuitably trained technician may interpret this as though removing a ground strap "fixed" a problem in the system since the isolation may recover sufficiently to remove the fault condition and allow the machine to resume operations.

It may also be that a grounding fault occurs over time causing the measured isolation resistance of a machine to improve despite ongoing degradation of the coolant.

A faulty ground connection, as indicated in **FIG. 3,** will likely produce wrong values of the electrical resistance of the fluid path **20, 21.** The ratio of switch **S1** is then no longer **R1:(R1+R2)** but instead **(R1+R5):(R1+R2+R5)** or **R1:(R1+R2+R5)** if switch **S1** grounds to the common chassis point **P** rather than to the radiator **12.**

The fuel cell stack **14** isolation resistance can be calculated when the contactors close and/or exit from internal measurements. This temporarily-valid value can be compared to the result of the switching to validate the ratio assumption and as a ground fault check. A known **(R1+R2):(R3+R4)** ratio can also be used while the coolant temperature of conduits 20, 21 is still homogenous. The temporarily valid value taken when the contactors close should match **(R1+R2)||(R3+R4),** i.e. the total stack contribution should be the **R1+R2** and **R3+R4** paths in parallel. If other non-monitored leakage paths are present and significant they will the source of the discrepancy between the values and can thus be estimated or indirectly measured by this.

**FIGS. 4A-C** schematically show electrical circuit diagrams during a method for detecting a ground fault, e.g. using an isolation resistance monitoring system **200** as described above. In a first state, shown in **FIG. 4A,** the fuel cell stack **10** is electrically disconnected from the traction voltage buses **16,** thereby not contributing with any isolation resistance. By measuring the total isolation resistance $\mathbf{R_{tot}}$, it follows that $\mathbf{R_{VEHICLE}} = \mathbf{R_{tot}}$. For the following, it is assumed that $\mathbf{R_{VEHICLE}} = \mathbf{R_{tot}} = 6M\Omega$.

As a next step, and as is shown in **FIG. 4B,** the fuel cell stack **10** is electrically connected to the traction voltage bus **16.** It is assumed that when again measuring the total isolation resistance, it has dropped to 3MΩ.

Since $\frac{1}{R_{tot}} = \frac{1}{R_{VEHICLE}} + \frac{1}{R_{FCS}}$, it follows that $\mathbf{R_{FCS}} = 6M\Omega$.

Although it may be potentially possible to determine if there is a faulty ground connection or not by comparing the values of $\mathbf{R_{tot}}$ before and after the fuel cell stack **14** has been electrically connected, as is shown in the simplified example of **FIG. 4C** a further measurement of the total isolation resistance is made after half of the resistance of the fuel cell stack **14** has been shorted. Hence, the new value **of** $\mathbf{R_{FCS}}$ should be 3MΩ which would result in an expected value of $\mathbf{R_{tot}} = 2M\Omega$. If the measured value of $\mathbf{R_{tot}}$ differs from this value it would be an indication of a ground fault.

An example of an isolation resistance monitoring system **200** is shown in **FIG. 5.** The isolation resistance monitoring system **200** comprises an isolation resistance data obtainer **220,** e.g. in the form of an isolation resistance monitoring device **210,** configured to obtain idle isolation resistance data **222** between a traction voltage pole **16A, 16B** of traction voltage buses **16** and a chassis **P** of a vehicle **1** when at least one vehicle subsystem, e.g. the fuel cell system **10,** is electrically disconnected from the traction voltage pole **16A, 16B.** When idle isolation resistance data is obtained, the at least one vehicle subsystem 10 is electrically connected to the traction voltage pole **16A, 16B.**

The isolation resistance data obtainer **220** is further configured to obtain first isolation resistance data **224** between a traction voltage pole **16A, 16B** of traction voltage buses **16** and a chassis **P** of a vehicle **1** when at least one vehicle subsystem, e.g. the fuel cell system **10,** is electrically connected to the traction voltage pole **16A, 16B.**

The ground fault detection system **200** further comprises a comparator **230** being configured to compare the first isolation resistance data **224** with the idle isolation resistance data **222,** and a faulty ground connection determinator **240** being configured to determine a faulty ground connection of the at least one vehicle subsystem **10** based on the comparison of the first isolation resistance data **224** with the idle isolation resistance data **222.**

The total isolation resistance $\mathbf{R_{tot}}$ will likely decrease when the vehicle subsystem **10,** i.e. the fuel cell system **10,** is electrically connected to the traction voltage buses **16.** When there is no faulty ground connection of the vehicle subsystem **10** the first isolation resistance data **224** will be significantly lower than the idle isolation resistance data **222.** However, if a faulty ground connection does exist, as in the example shown in **FIG. 3,** the first isolation resistance data **224** will be higher although still lower than the idle isolation resistance data **222.** Hence, by knowing and the absolute value of the first isolation resistance data **222, 224** when all ground connections are perfect, it is possible to identify a missing or faulty ground connection simply based on a comparison between the first isolation resistance data **222, 224** and an expected value.

For this purpose the ground fault detection system **200** comprises, or is configured to obtain, reference isolation resistance data **226.** The comparator **230** is configured to obtain the reference isolation resistance data **226** and use this when comparing the idle and first isolation resistance data **222, 224.** The reference isolation resistance data **226** may be predetermined or estimated, representing one or more threshold values, intervals, or ratios. For example, if the reference isolation resistance data is 3MΩ, a faulty ground connection may be determined by the faulty ground connection determinator **240** only when the first isolation resistance data **224** is above this value. In another example, the reference isolation resistance data may be a factor of 0,5. Hence a faulty ground connection may be determined by the faulty ground connection determinator **240** only when the first isolation resistance data **224** is above 50% of the idle isolation resistance data **224.** The comparator **230** may be further configured to obtain, e.g. by determining, an isolation resistance difference between the idle isolation resistance data **222** and the first isolation resistance data **224,** and using reference isolation resistance data **226** in the form of a pre-determined reference difference when comparing the obtained isolation resistance difference with the pre-determined reference difference **226.**

In some examples, the reference isolation resistance data **226** is used for a plausibility check, mainly resulting in four different outcomes: i) everything is within acceptable limits as the first isolation resistance data **224** is reasonable and with confidence, ii) indeterminate, as the plausible value has low confidence, iii) switch is broken when there is no expected response, and iv) most likely a ground fault when there is a reliable discrepancy.

Alternatively, the reference isolation resistance data **226** may be obtained as a predetermined reference difference interval.

As mentioned earlier, the faulty ground connection determinator **240** may be configured to determine a faulty ground connection of the at least one vehicle subsystem **10** when the first isolation resistance data **224** is less than the idle isolation resistance data **222.**

As shown in **FIG. 5** the isolation resistance monitoring system **200** comprises a switch controller **250.** The switch controller **250** is configured to electrically short circuit a leakage path of the at least one vehicle subsystem **10** by controlling one or more switches **S1, S2.** When at least one of said switches **S1, S2** is closed one or more leakage paths of the vehicle subsystem **10** is electrically short circuited. In this mode, the isolation resistance data obtainer **220** is configured to obtain second isolation resistance data **228** between the traction voltage pole **16** and the chassis **P.**

The second isolation resistance data **228** is used by the comparator **230,** which is further configured to compare the second isolation resistance data **228** with the first isolation resistance data **224.** Based on this comparison, a fluid resistance determinator **260** is configured to determine the electrical resistance of the fluid or coolant flowing in the conduit **20, 21** of the at least one vehicle subsystem **10** based on the result of the comparison of the second isolation resistance data **228** with the first isolation resistance data **224.**

Since the electrical conductivity of the coolant flowing in the conduits **20, 21** may be temperature dependent, the isolation resistance data obtainer **220** may be configured to obtain first and/or second isolation resistance data **224, 228** for each one of a plurality of temperatures of the at least one vehicle subsystem **10.** The fluid resistance determinator **260** may consequently be configured to determine a relationship between electrical resistance and temperature.

In order to determine the electrical resistance of the fluid flowing in the conduit(s) **20, 21,** geometrical data 252 (including a geometrical ratio) is used as input for the fluid resistance determinator **260.**

From the electrical resistance of the fluid, as determined by the fluid resistance determinator **260,** a fluid conductivity determinator **270** may be configured to determine the electrical conductivity of the fluid flowing in the conduit(s) **20, 21.**

Now turning to **FIGS. 6-8,** a process **300** for monitoring one or more electrical properties of an electrically conducting fluid path will be described. For better understanding, the process **300** will be explained with reference to the system shown in **FIG. 3.**

Starting in **FIG. 6,** the process **300** is initiated when the fuel cell system **10** is connected to the traction voltage buses **16,** and when both switches **S1, S2** are open. After process start **302** and after ensuring **304** everything is connected properly, the process **300** determines **306** the first isolation resistance $\mathbf{R_{0+0}}$.

In **308** the first switch **S1** is closed, and the second isolation resistance $\mathbf{R_{S1+0}}$ is determined **310.** When knowing both $\mathbf{R_{0+0}}$ and $R_{S1+0}$, a comparison **312** is made. If values are unstable a flag may be raised and if $\mathbf{R_{S1+0}} >= \mathbf{R_{0+0}}$, a ground fault warning may be issued **314.** Assuming a total length **L** of conduit **20,** and a length **L'** of the conduit **20** upstream the switch **S1,** it is possible to determine **316** a length factor $\mathbf{X_{S1}}$ **= L'/L.**

Following this, the process **300** resolves a path resistance **318,** such as determining the resistance $\mathbf{R_{S1}}$, via a known proportionality factor **316** governing the change and the remainder of unknowns making up the total remaining sufficiently constant.

$$R_{S1} = \frac{(1-X_{S1})}{X_{S1}(R_{S1+0}^{-1}-R_{0+0}^{-1})}.$$

The proportionality factor **316** may be obtained by system characterization, comparison of resistance measurements $\mathbf{X_{S1}}$ **= R'/R,** or geometrically. For example with constant or compensated cross-sectional area, a total effective length **L** of conduit **20,** and an effective length **L'** of the conduit **20** on one side of the switch **S1,** it is possible to determine proportionality **316** via a length factor $\mathbf{X_{S1}}$ **= L'/L.**

Further obtaining **320** a cross-sectional area $\mathbf{A_{s1}}$ the length **L** (in some cases also the integral **of L/A** for non-constant sections) of the conduit **20,** it is possible to determine 322 the conductivity $\boldsymbol{\sigma_{S1}}$ of the fluid flowing inside the conduit **20** as $\sigma_{S1} = \frac{L_{S1}}{A_{S1} \cdot R_{S1}}$. By also knowing the temperature **T** at the time of the measurements, it is possible to map **324** the determined conductivity $\boldsymbol{\sigma_{S1}}$ as a function of temperature.

As shown in **FIG. 7** the process **300** continues generally by repeating the above process but for the second conduit **21.** In **322** the second switch **S2** is closed, and a third isolation resistance $R_{0+S2}$ is determined **324.** When knowing both $R_{0+0}$ and $R_{0+S2}$, a comparison **326** is made. If $R_{0+S2} >= R_{0+0}$, a ground fault warning is issued **328.** Assuming a total length **L** of conduit **21,** and a length **L'** of the conduit **21** upstream the switch **S2,** it is possible to determine **330** a length factor $X_{S2} = L'/L$.

Following this, the process **300** determines **332** the resistance $R_{S2}$ over the coolant path conduit **21** as $R_{S2} = \frac{(1-X_{s2})}{X_{s2}(R_{0+s2}^{-1}-R_{0+0}^{-1})}$.

Further assuming **334** a cross-sectional area $A_{s2}$ of the conduit **21,** it is possible to determine **336** the conductivity $\sigma_{S2}$ of the fluid flowing inside the conduit **21** as $\sigma_{S2} = \frac{L_{s2}}{A_{s2} \cdot R_{s2}}$.

As is shown in **FIG. 8** the process **300** further continues in determining a predicted isolation resistance of the vehicle. From knowing the conductivities $\sigma_{S1}$, $\sigma_{S2}$ and the actual temperatures at these conductivities, the derivative $\frac{d\sigma}{dT} = \frac{\sigma_{s2}-\sigma_{s1}}{T_2 - T_1}$ is determined **336.**

From this function, and based on a maximum temperature $T_{max}$, the maximum conductivity $\sigma_{max}$ is determined **338.** Further, an isolation resistance $R_{BoV}$ considering balance of the vehicle is determined **340** as

$$R_{BoV} = \frac{1}{R_{0+0}^{-1} \mp R_{s1}^{-1} \mp R_{s2}^{-1}}$$

. From this value $R_{BoV}$, a predicted isolation resistance is determined **342** as

$$R_{s1+s2(predicted)} = \frac{1}{R_{BoV}^{-1} \mp X_{s1} \cdot R_{s1}^{-1} \mp X_{s2} \cdot R_{s2}^{-1}}.$$

**FIG. 9** shows an isolation resistance monitoring system **200** according to one example. The isolation resistance monitoring system **200** comprises an isolation resistance data obtainer **220,** e.g. in the form of an isolation resistance monitoring device **210,** configured to obtain first isolation resistance data **224** between a traction voltage pole **16A, 16B** of traction voltage buses **16** and a chassis **P** of a vehicle **1** when at least one vehicle subsystem, e.g. a fuel cell system **10,** is electrically connected to the traction voltage pole **16A, 16B.** The at least one vehicle subsystem **10** comprising at least a first electrically conducting fluid path **20, 21.**

The isolation resistance monitoring system **200** comprises a switch controller **250.** The switch controller **250** is configured to electrically short circuit a first portion, i.e. a leakage path, of the first fluid path **20, 21** to the ground potential **P.** The isolation resistance data obtainer **220** is further configured to obtain second isolation resistance data **228** between the traction voltage pole **16A, 16B** of traction voltage buses **16** and a chassis **P** of a vehicle **1** when the first portion of the first fluid path **20, 21** is short-circuited.

The isolation resistance monitoring system **200** further comprises a fluid resistance determinator **260** configured to determine the electrical resistance of the fluid of the first fluid path **20, 21** of the at least one vehicle subsystem **10** based on the first isolation resistance data **224** and the second isolation resistance data **228.**

As explained above with reference to **FIG. 3,** the primary purpose of this disclosure is to ascertain how much of the vehicles total isolation resistance is leaking via a significant conduit of the slightly conductive dielectric fluid used for direct cooling and then to exploit this knowledge to gain more information than isolation monitoring devices can otherwise provide, and also additional and more targeted information than a coolant conductivity sensor can provide. Making a change to the path itself is the safest way to do this and exploiting proportionality can allow this to be done with just a relay or ultra-low-leakage transistor along with observations from existing measurement devices. Since this is less of a direct measurement compared to a dedicated conductivity sensor more plausibility checks may be required to ensure that safety and functionality are improved even when the conductivity sensor is no longer used. A grounding fault is a main reason why measurements could fail plausibility checks and hence the aspects described herein could identify a ground fault. The disclosure also helps to provide valuable additional information which could be used by (or the core data in) a wider ground fault detection scheme.

Shorts should be large enough to provide some accuracy (i.e. a significant change) but not so large so as to produce dangerous leakage currents or trigger faults in the vehicle. Larger shorts will typically drop voltages at unbonded components and will not affect potential earthed components. The primary approach is to make use of an isolation measurement device already fitted and relies on performing software calculations based on the measurements taken by this device rather than introducing voltage, current or conductivity measurement devices to the system.

In some cases specific components may be isolated or able to isolate if they can do so safely so as to change the length of a leakage path without creating a danger. This refers to either "floating" components which are exposed to potential via a resistive path or exposing nomally ground-bonded resistive paths to a potential voltage source. This uses the geometric data for conductivity but is not proportional in the divided path sense giving a simplification with regards to deducing coolant conductivity but not providing a direct means for checking an in-tact leakage path. This may affect material choice and layout to provide a best optimization. Start up and shutdown routines may be tailored to exploit such approaches. Performing multiple calculations while the system warms up can help to generate data on the actual relationship between temperature and conductivity. Further, temporary temperature deviations may also be used to check such values while operating or to allow such calculation or compensation to be performed with simpler implementations.

It is thus preferable that the temperatures of analyzed volumes are available and mixing and other deviations avoided. Analysis of two significantly different temperatures can give good thermal coefficient data/-compensation but two similar temperature volumes can be easier for sensitivity analysis. Temporary complete coolant flow diversions may be used to isolate leakage paths for the purposes of making calculations possible. By shorting a significant amount of resistance in a leakage path to a grounded component both the effectiveness of this resistance and the presence of a grounding connection in this path can be checked as described in the following. This may be to isolate or connect paths eg a valve in the coolant. In this case it can follow the floating paths or components simplification with X=1 as above but can also be proportional depending on the layout/situation.

Further examples of fuel cell system **10,** comprising a ground fault detection system **200,** are shown in **FIGS. 10-12.**

Starting in **FIG. 10,** a multi-way valve (e.g. a mixing or blending valve) or flow blocking valve **270** is constructed so as to be able to selectively isolate the leakage of electrical current through a coolant line **20** to the chassis ground **P.**

The isolation resistance value can be raised in a safe way but generally not while the system is running since the flow of coolant must be shut off. A mixed example whereby the isolation resistance is intentionally raised via this method and then dropped via a short can improve accuracy.

This could be on the "fuel cell stack" side of **R1, R2,** it could split **R1** and **R2,** and could introduce another resistance on the bypass line. Ground fault detection algorithm remains solvable provided the proportionality is known. This likely means a valve body with some specific considerations and made from polymers although many existing devices would appear to meet these requirements.

Before and/or during start and after shutdown the **R1** leakage path can then be temporarily blocked, raising the isolation resistance measurement but without allowing voltages to raise on components. If **R1** is proportional to **R2** then the contribution of **R1, R2** can be separated from **R3** and as in prior examples the coolant conductivity can be calculated from **R1** and/or **R2** plus the hose geometry and when unusually low the need to check for potentially missing ground connections can be flagged.

In **FIG. 11** the radiator bypass valve **270** never has to block flow to the fuel cell system **10** since it can instead block one of two ports. This valve **270** then operates as a switch between 3 states: **(R1+R2), (R1+R3), (R1** + **R2:R3).** In order to provide useful accuracy **R2** and **R3** must be as different as possible. Ideally a transition readily available to the system has a large difference and the most reliable way to achieve this is a relatively small **R1** and larger **R2** and **R3.** For practical reasons **R1** is typically large and **R2** is typically tending to zero and then a large **R3** becomes preferred. When **R2** becomes 0, this becomes the short in the regular switch method when the valve is not "fully diverted" via **R3.**

The first two cases only occur when flow is 100% to radiator **12** or 100% diverted respectively.Temperature preferably needs to be considered in this approach and in an ideal situation **R2** and **R3** could be brought to similar temperature.

In **FIG. 12** another example is shown. Switch **S1** selectively floats a subsystem **13.** Here some coolant is bypassed via some other components **13** (for example a charge air cooler) on the live side. If these components are not grounded then this whole path does not then leak to ground. By selectively grounding them R4:R5 can be found directly from the change in the vehicle total. R1:R2 are not directly measured in this case but could be proportional to R4:R5.

**FIG.** 13 is a flow chart of a method **400** of ground fault detection according to an example. The computer-implemented method comprises electrically connecting **402,** by processing circuitry of a computer system, at least one vehicle subsystem **10** to a traction voltage pole **16A, 16B** of a vehicle **1** and to a ground potential **P.** The at least one vehicle subsystem **10** comprises at least a first electrically conducting fluid path **20, 21.**

The method **400** further comprises obtaining **404,** by the processing circuitry, first isolation resistance data **224** between the traction voltage pole **16A, 16B** and the ground potential **P,** and electrically short-circuiting **406,** by the processing circuitry, a first portion of the first fluid path **20, 21** to the ground potential **P.**

The method **400** further comprises obtaining **408,** by the processing circuitry, second isolation resistance data **228** between the traction voltage pole **16A, 16B** and the ground potential **P** when the first portion of the first fluid path **20, 21** is short-circuited; and determining **410,** by the processing circuitry, the added or connected electrical resistance of the fluid of the first fluid path **20, 21** of the at least one vehicle subsystem **10** based on the first isolation resistance data **224** and the second isolation resistance data **228.** Optionally, the method **400** may further comprise determining **412** a faulty ground connection based on the obtained isolation resistance data.

**FIG. 14** is a schematic diagram of a computer system **500** for implementing examples disclosed herein. The computer system **500** is adapted to execute instructions from a computer-readable medium to perform these and/or any of the functions or processing described herein. The computer system **500** may be connected (e.g., networked) to other machines in a LAN, an intranet, an extranet, or the Internet. While only a single device is illustrated, the computer system **500** may include any collection of devices that individually or j ointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **500** may comprise at least one computing device or electronic device capable of including firmware, hardware, and/or executing software instructions to implement the functionality described herein. The computer system **500** may include processing circuitry **502** (e.g., processing circuitry including one or more processor devices or control units), a memory **504,** and a system bus **506.** The computer system **500** may include at least one computing device having the processing circuitry **502.** The system bus **506** provides an interface for system components including, but not limited to, the memory **504** and the processing circuitry **502.** The processing circuitry **502** may include any number of hardware components for conducting data or signal processing or for executing computer code stored in memory **504.** The processing circuitry **502** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **502** may further include computer executable code that controls operation of the programmable device.

The system bus **506** may be any of several types of bus structures that may further interconnect to a memory bus (with or without a memory controller), a peripheral bus, and/or a local bus using any of a variety of bus architectures. The memory **504** may be one or more devices for storing data and/or computer code for completing or facilitating methods described herein. The memory **504** may include database components, object code components, script components, or other types of information structure for supporting the various activities herein. Any distributed or local memory device may be utilized with the systems and methods of this description. The memory **504** may be communicably connected to the processing circuitry **502** (e.g., via a circuit or any other wired, wireless, or network connection) and may include computer code for executing one or more processes described herein. The memory **504** may include non-volatile memory **508** (e.g., read-only memory (ROM), erasable programmable read-only memory (EPROM), electrically erasable programmable read-only memory (EEPROM), etc.), and volatile memory **510** (e.g., random-access memory (RAM)), or any other medium which can be used to carry or store desired program code in the form of machine-executable instructions or data structures and which can be accessed by a computer or other machine with processing circuitry **502.** A basic input/output system (BIOS) **512** may be stored in the non-volatile memory **508** and can include the basic routines that help to transfer information between elements within the computer system **500.**

The computer system **500** may further include or be coupled to a non-transitory computer-readable storage medium such as the storage device **514,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **514** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **514** and/or in the volatile memory **510,** which may include an operating system **516** and/or one or more program modules **518.** All or a portion of the examples disclosed herein may be implemented as a computer program **520** stored on a transitory or non-transitory computer-usable or computer-readable storage medium (e.g., single medium or multiple media), such as the storage device **514,** which includes complex programming instructions (e.g., complex computer-readable program code) to cause the processing circuitry **502** to carry out actions described herein. Thus, the computer-readable program code of the computer program **520** can comprise software instructions for implementing the functionality of the examples described herein when executed by the processing circuitry **502.** In some examples, the storage device **514** may be a computer program product (e.g., readable storage medium) storing the computer program **520** thereon, where at least a portion of a computer program **520** may be loadable (e.g., into a processor) for implementing the functionality of the examples described herein when executed by the processing circuitry **502.** The processing circuitry **502** may serve as a controller or control system for the computer system **500** that is to implement the functionality described herein.

The computer system **500** may include an input device interface **522** configured to receive input and selections to be communicated to the computer system **500** when executing instructions, such as from a keyboard, mouse, touch-sensitive surface, etc. Such input devices may be connected to the processing circuitry **502** through the input device

interface **522** coupled to the system bus **506** but can be connected through other interfaces, such as a parallel port, an Institute of Electrical and Electronic Engineers (IEEE) 1394 serial port, a Universal Serial Bus (USB) port, an IR interface, and the like. The computer system **500** may include an output device interface **524** configured to forward output, such as to a display, a video display unit (e.g., a liquid crystal display (LCD) or a cathode ray tube (CRT)). The computer system **500** may include a communications interface **526** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

**Example 1:** A computer system comprising processing circuitry configured to: electrically connect at least one vehicle subsystem (10) to a traction voltage pole (16, 16A, 16B) of a vehicle (1) and to a ground potential (P), said at least one vehicle subsystem (10) comprising at least a first electrically conducting fluid path (20, 21); obtain first isolation resistance data (224) between the traction voltage pole (16, 16A, 16B) and the ground potential (P); electrically short-circuit a first portion of the first fluid path (20, 21) to the ground potential (P); obtain second isolation resistance data (228) between the traction voltage pole (16, 16A, 16B) and the ground potential (P) when the first portion of the first fluid path (20, 21) is short-circuited; and determine the electrical resistance of the fluid of the first fluid path (20, 21) of the at least one vehicle subsystem (10) based on the first isolation resistance data (224) and the second isolation resistance data (228).

**Example 2:** The computer system of Example 1, wherein the processing circuitry is further configured to: obtain a geometrical ratio between the first portion of the first fluid path (20, 21) and the entire fluid path (20, 21); and determine the electrical resistance of the fluid of the fluid path (20, 21) of the at least one vehicle subsystem (10) based on the geometrical ratio.

**Example 3:** The computer system of Example 1 or 2, wherein the processing circuitry is further configured to: determine the conductivity of the fluid of the first fluid path (20, 21) based on the determined electrical resistance.

**Example 4:** The computer system of any of Examples 1-3, wherein the at least one vehicle subsystem (10) further comprises a second electrically conducting fluid path (20, 21), and wherein the processing circuitry is further configured to: electrically short-circuit a first portion of the second fluid path (20, 21) to the ground potential (P); obtain third isolation resistance data (228) between the traction voltage pole (16, 16A, 16B) and the ground potential (P) when the first portion of the second fluid path (20, 21) is short-circuited; and determine the electrical resistance of the fluid of the second fluid path (20, 21) of the at least one vehicle subsystem (10) based on the first isolation resistance data (224) and the third isolation resistance data (228).

**Example 5:** The computer system of any of Examples 1-4, wherein the processing circuitry is further configured to: obtain the temperature of the fluid of the first and/or second fluid path (20, 21); and determine a relationship between the electrical resistance of the fluid of the first and/or second fluid path (20, 21) and temperature.

**Example 6:** The computer system of any of Examples 1-5, wherein the processing circuitry is further configured to: electrically disconnect the at least one vehicle subsystem (10) from the traction voltage pole (16, 16A, 16B); obtain idle isolation resistance data (222) between the traction voltage pole (16, 16A, 16B) and the ground potential (P) when at least one vehicle subsystem (10) is electrically disconnected from the traction voltage pole (16, 16A, 16B); and determine a faulty ground connection of the at least one vehicle subsystem (10) based on the idle isolation resistance data (222) and the first isolation resistance data

(224).

**Example 7:** The computer system of Example 1, wherein the processing circuitry is further configured to: obtain a geometrical ratio between the first portion of the first fluid path (20, 21) and the entire fluid path (20, 21); determine the electrical resistance of the fluid of the fluid path (20, 21) of the at least one vehicle subsystem (10) based on the geometrical ratio; determine the conductivity of the fluid of the first fluid path (20, 21) based on the determined electrical resistance; wherein the at least one vehicle subsystem (10) further comprises a second electrically conducting fluid path (20, 21), and wherein the processing circuitry is further configured to: electrically short-circuit a first portion of the second fluid path (20, 21) to the ground potential (P); obtain third isolation resistance data (228) between the traction voltage pole (16, 16A, 16B) and the ground potential (P) when the first portion of the second fluid path (20, 21) is short-circuited; and determine the electrical resistance of the fluid of the second fluid path (20, 21) of the at least one vehicle subsystem (10) based on the first isolation resistance data (224) and the third isolation resistance data (228); obtain the temperature of the fluid of the first and/or second fluid path (20, 21); and determine a relationship between the electrical resistance of the fluid of the first and/or second fluid path (20, 21) and temperature; and, prior to electrically connect at least one vehicle subsystem (10) to a traction voltage pole (16, 16A, 16B) of a vehicle (1) and to a ground potential (P), the processing circuitry is further configured to: electrically disconnect the at least one vehicle subsystem (10) from the traction voltage pole (16, 16A, 16B); obtain idle isolation resistance data (222) between the traction voltage pole (16, 16A, 16B) and the ground potential (P) when at least one vehicle subsystem (10) is electrically disconnected from the traction voltage pole (16, 16A, 16B); and determine a faulty ground connection of the at least one vehicle subsystem (10) based on the idle isolation resistance data (222) and the first isolation resistance data (224).

**Example 8:** A vehicle comprising the computer system of any of Examples 1-7.

**Example 9:** The vehicle of Example 8, further comprising at least one fuel cell system (10, 14) forming the vehicle subsystem (10).

**Example 10:** The vehicle of Example 9, wherein the at least one fuel cell system (10, 14) comprises at least one coolant channel (20, 21) connected to a radiator (12) and/or to a pump (11), and wherein the coolant channel (20, 21) forms at least a first fluid path (20, 21).

**Example 11:** The vehicle of Example 10, further comprising a first switch (S1) configured to short circuit a first portion of the first fluid path (20, 21).

**Example 12:** The vehicle of Example 11, further comprising a second switch (S2) configured to short circuit a first portion of the second fluid path (20, 21).

**Example 13:** A computer-implemented method, comprising: electrically connecting, by processing circuitry of a computer system, at least one vehicle subsystem (10) to a traction voltage pole (16, 16A, 16B) of a vehicle (1) and to a ground potential (P), said at least one vehicle subsystem (10) comprising at least a first electrically conducting fluid path (20, 21); obtaining, by the processing circuitry, first isolation resistance data (224) between the traction voltage pole (16, 16A, 16B) and the ground potential (P); electrically short-circuiting, by the processing circuitry, a first portion of the first fluid path (20, 21) to the ground potential (P); obtaining, by the processing circuitry, second isolation resistance data (228) between the traction voltage pole (16, 16A, 16B) and the ground potential (P) when the first portion of the first fluid path (20, 21) is short-circuited; and determining, by the processing circuitry, the electrical resistance of the fluid of the first fluid path (20, 21) of the at least one vehicle subsystem (10) based on the first isolation resistance data (224) and the second isolation resistance data (228).

**Example 14:** The method of Example 13, further comprising: obtaining, by the processing circuitry, the geometrical ratio between the first portion of the first fluid path (20, 21) and the entire fluid path (20, 21); and determining, by the processing circuitry, the electrical resistance of the fluid of the fluid path (20, 21) of the at least one vehicle subsystem (10) based on the geometrical ratio.

**Example 15:** The method of Example 13 or 14, further comprising: determining, by the processing circuitry, the conductivity of the fluid of the first fluid path (20, 21) based on the determined electrical resistance.

**Example 16:** The method of any of Examples 13-15, wherein the at least one vehicle subsystem (10) further comprises a second electrically conducting fluid path (20, 21), and wherein the method further comprises: electrically short-circuiting, by the processing circuitry, a first portion of the second fluid path (20, 21) to the ground potential (P); obtaining, by the processing circuitry, third isolation resistance data (228) between the traction voltage pole (16, 16A, 16B) and the ground potential (P) when the first portion of the second fluid path (20, 21) is short-circuited; and determining, by the processing circuitry, the electrical resistance of the fluid of the second fluid path (20, 21) of the at least one vehicle subsystem (10) based on the first isolation resistance data (224) and the third isolation resistance data (228).

**Example 17:** The method of any of Examples 13-16, further comprising: obtaining, by the processing circuitry, the temperature of the fluid of the first and/or second fluid path (20, 21); and determining, by the processing circuitry, a relationship between the electrical resistance of the fluid of the first and/or second fluid path (20, 21) and temperature.

**Example 18:** The method of any of Examples 13-17, further comprising: electrically disconnecting, by the processing circuitry, the at least one vehicle subsystem (10) from the traction voltage pole (16, 16A, 16B); obtaining, by the processing circuitry, idle isolation resistance data (222) between the traction voltage pole (16, 16A, 16B) and the ground potential (P) when at least one vehicle subsystem (10) is electrically disconnected from the traction voltage pole (16, 16A, 16B); and determining, by the processing circuitry, a faulty ground connection of the at least one vehicle subsystem (10) based on the idle isolation resistance data (222) and the first isolation resistance data (222).

**Example 19:** A computer program product comprising program code for performing, when executed by the processing circuitry, the method of any of Examples 13-18.

**Example 20:** A non-transitory computer-readable storage medium comprising instructions, which when executed by the processing circuitry, cause the processing circuitry to perform the method of any of Examples 13-18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

**1.** A computer system comprising processing circuitry configured to:

electrically connect at least one vehicle subsystem (10) to a traction voltage pole (16, 16A, 16B) of a vehicle (1) and to a ground potential (P), said at least one vehicle subsystem (10) comprising at least a first electrically conducting fluid path (20, 21);

obtain first isolation resistance data (224) between the traction voltage pole (16, 16A, 16B) and the ground potential (P);

electrically short-circuit a first portion of the first fluid path (20, 21);

obtain second isolation resistance data (228) between the traction voltage pole (16, 16A, 16B) and the ground potential (P) when the first portion of the first fluid path (20, 21) is short-circuited; and

determine the electrical resistance of the fluid of the first fluid path (20, 21) of the at least one vehicle subsystem (10) based on the first isolation resistance data (224) and the second isolation resistance data (228).

**2.** The computer system of claim 1, wherein the processing circuitry is further configured to:

obtain a geometrical ratio between the first portion of the first fluid path (20, 21) and the entire fluid path (20, 21); and

determine the electrical resistance of the fluid of the fluid path (20, 21) of the at least one vehicle subsystem (10) based on the geometrical ratio.

**3.** The computer system of claim 1 or 2, wherein the processing circuitry is further configured to:
determine the conductivity of the fluid of the first fluid path (20, 21) based on the determined electrical resistance.

**4.** The computer system of any of claims 1-3, wherein the at least one vehicle subsystem (10) further comprises a second electrically conducting fluid path (20, 21), and wherein the processing circuitry is further configured to:

electrically short-circuit a first portion of the second fluid path (20, 21);

obtain third isolation resistance data (228) between the traction voltage pole (16, 16A, 16B) and the ground potential (P) when the first portion of the second fluid path (20, 21) is short-circuited; and

determine the electrical resistance of the fluid of the second fluid path (20, 21) of the at least one vehicle subsystem (10) based on the first isolation resistance data (224) and the third isolation resistance data (228).

**5.** The computer system of any of claims 1-4, wherein the processing circuitry is further configured to:

obtain the temperature of the fluid of the first and/or second fluid path (20, 21); and
determine a relationship between the electrical conductivity of the fluid of the first and/or second fluid path (20, 21) and temperature.

6. The computer system of any of claims 1-5, wherein the processing circuitry is further configured to:

electrically disconnect the at least one vehicle subsystem (10) from the traction voltage pole (16, 16A, 16B);
obtain idle isolation resistance data (222) between the traction voltage pole (16, 16A, 16B) and the ground potential (P) when at least one vehicle subsystem (10) is electrically disconnected from the traction voltage pole (16, 16A, 16B); and
determine a faulty ground connection of the at least one vehicle subsystem (10) based on the idle isolation resistance data (222) and the first isolation resistance data (224).

7. The computer system of claim 1, wherein the processing circuitry is further configured to:

obtain a geometrical ratio between the first portion of the first fluid path (20, 21) and the entire fluid path (20, 21);
determine the electrical resistance of the fluid of the fluid path (20, 21) of the at least one vehicle subsystem (10) based on the geometrical ratio;
determine the conductivity of the fluid of the first fluid path (20, 21) based on the determined electrical resistance;
wherein the at least one vehicle subsystem (10) further comprises a second electrically conducting fluid path (20, 21), and wherein the processing circuitry is further configured to:

electrically short-circuit a first portion of the second fluid path (20, 21);
obtain third isolation resistance data (228) between the traction voltage pole (16, 16A, 16B) and the ground potential (P) when the first portion of the second fluid path (20, 21) is short-circuited; and
determine the electrical resistance of the fluid of the second fluid path (20, 21) of the at least one vehicle subsystem (10) based on the first isolation resistance data (224) and the third isolation resistance data (228);
obtain the temperature of the fluid of the first and/or second fluid path (20, 21); and
determine a relationship between the electrical conductivity of the fluid of the first and/or second fluid path (20, 21) and temperature; and, prior to electrically connect at least one vehicle subsystem (10) to a traction voltage pole (16, 16A, 16B) of a vehicle (1) and to a ground potential (P), the processing circuitry is further configured to:

electrically disconnect the at least one vehicle subsystem (10) from the traction voltage pole (16, 16A, 16B);
obtain idle isolation resistance data (222) between the traction voltage pole (16, 16A, 16B) and the ground potential (P) when at least one vehicle subsystem (10) is electrically disconnected from the traction voltage pole (16, 16A, 16B); and
check the conductivity of the fluid of the first fluid path at a specific temperature against the conductivity of the fluid of the second fluid path at the same specific temperature.

8. A vehicle comprising the computer system of any of claims 1-7.

9. The vehicle of claim 8, further comprising at least one fuel cell system (10, 14) or an immersion cooled battery system forming the vehicle subsystem (10).

10. The vehicle of claim 9, wherein the at least one fuel cell system (10, 14) or immersion cooled batter system comprises at least one coolant channel (20, 21) connected to a radiator (12) and/or to a pump (11), and wherein the coolant channel (20, 21) forms at least a first fluid path (20, 21).

11. The vehicle of claim 10, further comprising a first switch (S1) configured to short circuit a first portion of the first fluid path (20, 21).

12. The vehicle of claim 11, further comprising a second switch (S2) configured to short circuit a first portion of the second fluid path (20, 21).

13. A computer-implemented method, comprising:

electrically connecting, by processing circuitry of a computer system, at least one vehicle subsystem (10) to a traction voltage pole (16, 16A, 16B) of a vehicle (1) and to a ground potential (P), said at least one vehicle subsystem (10) comprising at least a first electrically conducting fluid path (20, 21);
obtaining, by the processing circuitry, first isolation resistance data (224) between the traction voltage pole (16, 16A, 16B) and the ground potential (P);
electrically short-circuiting, by the processing circuitry, a first portion of the first fluid path (20, 21);
obtaining, by the processing circuitry, second isolation resistance data (228) between the traction voltage pole (16, 16A, 16B) and the ground potential (P) when the first portion of the first fluid path (20, 21) is short-circuited; and
determining, by the processing circuitry, the electrical resistance of the fluid of the first fluid path (20, 21) of the at least one vehicle subsystem (10) based on the first isolation resistance data (224) and the second isolation resistance data (228).

**14.** A computer program product comprising program code for performing, when executed by the processing circuitry, the method of claim 13.

**15.** A non-transitory computer-readable storage medium comprising instructions, which when executed by the processing circuitry, cause the processing circuitry to perform the method of claim 13.

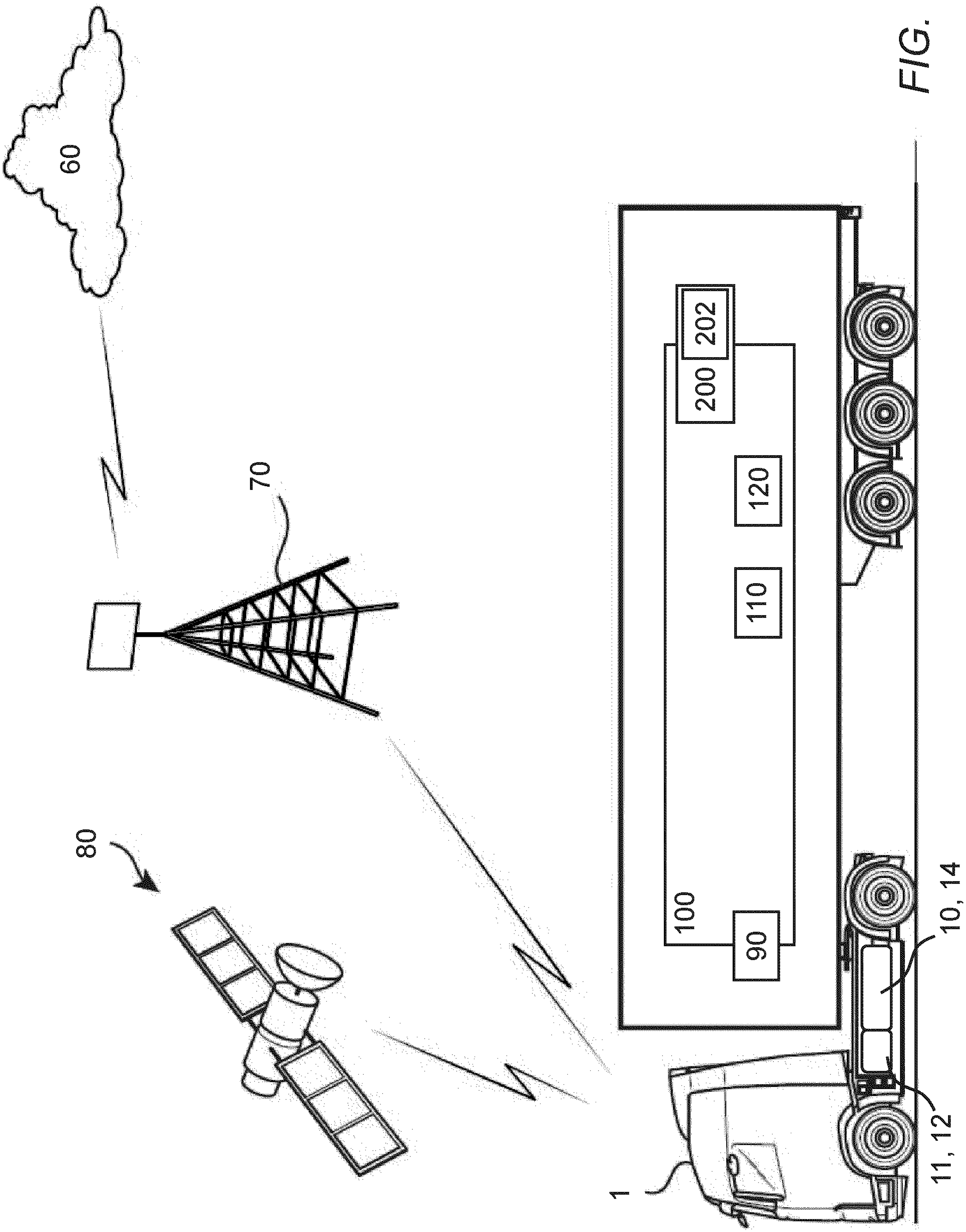


FIG. 1

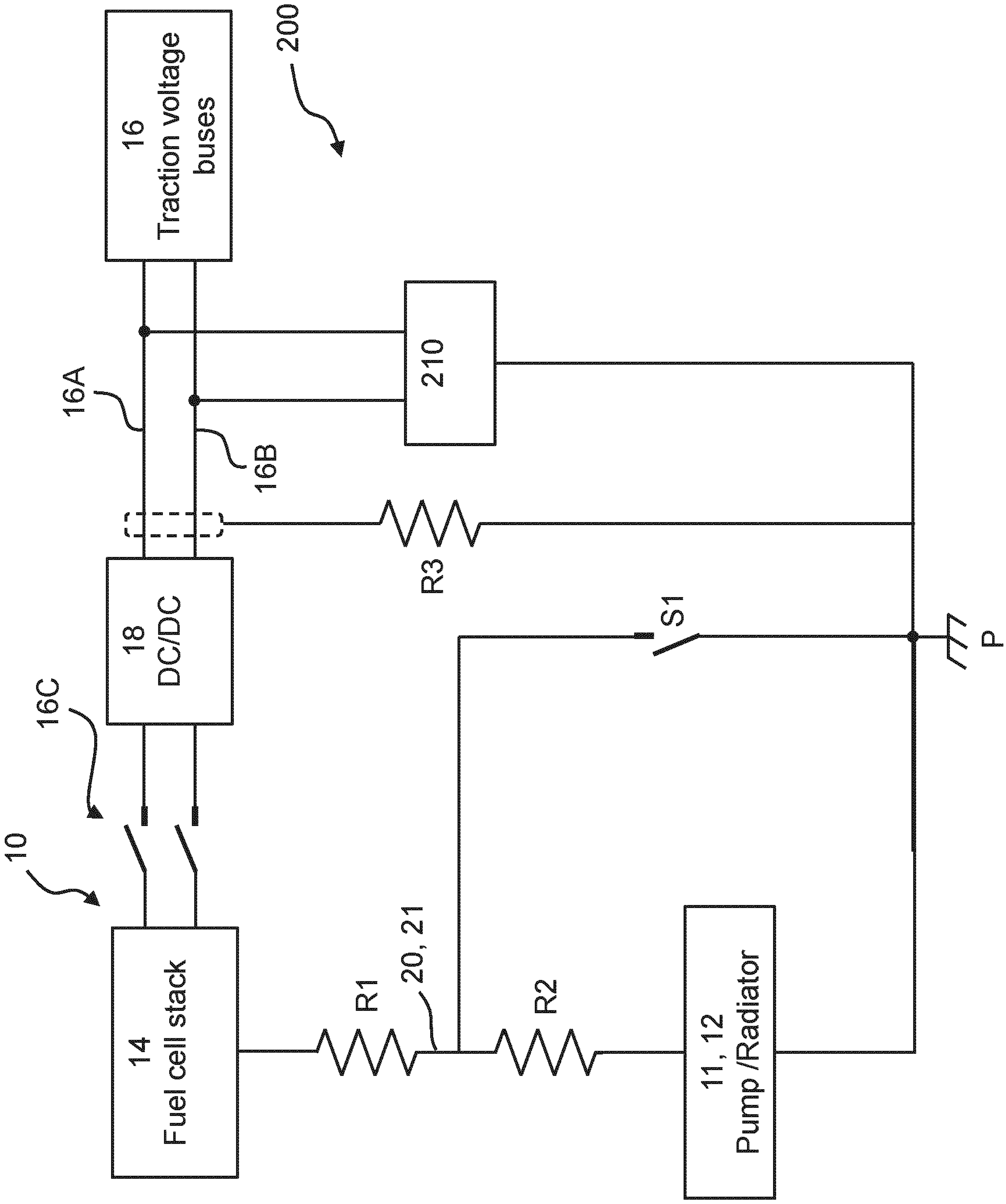
16
Traction voltage
buses
200
210
16A
16B
R3
18
DC/DC
16C
10
S1
P
14
Fuel cell stack
R1
20, 21
R2
11, 12
Pump /Radiator

FIG. 2

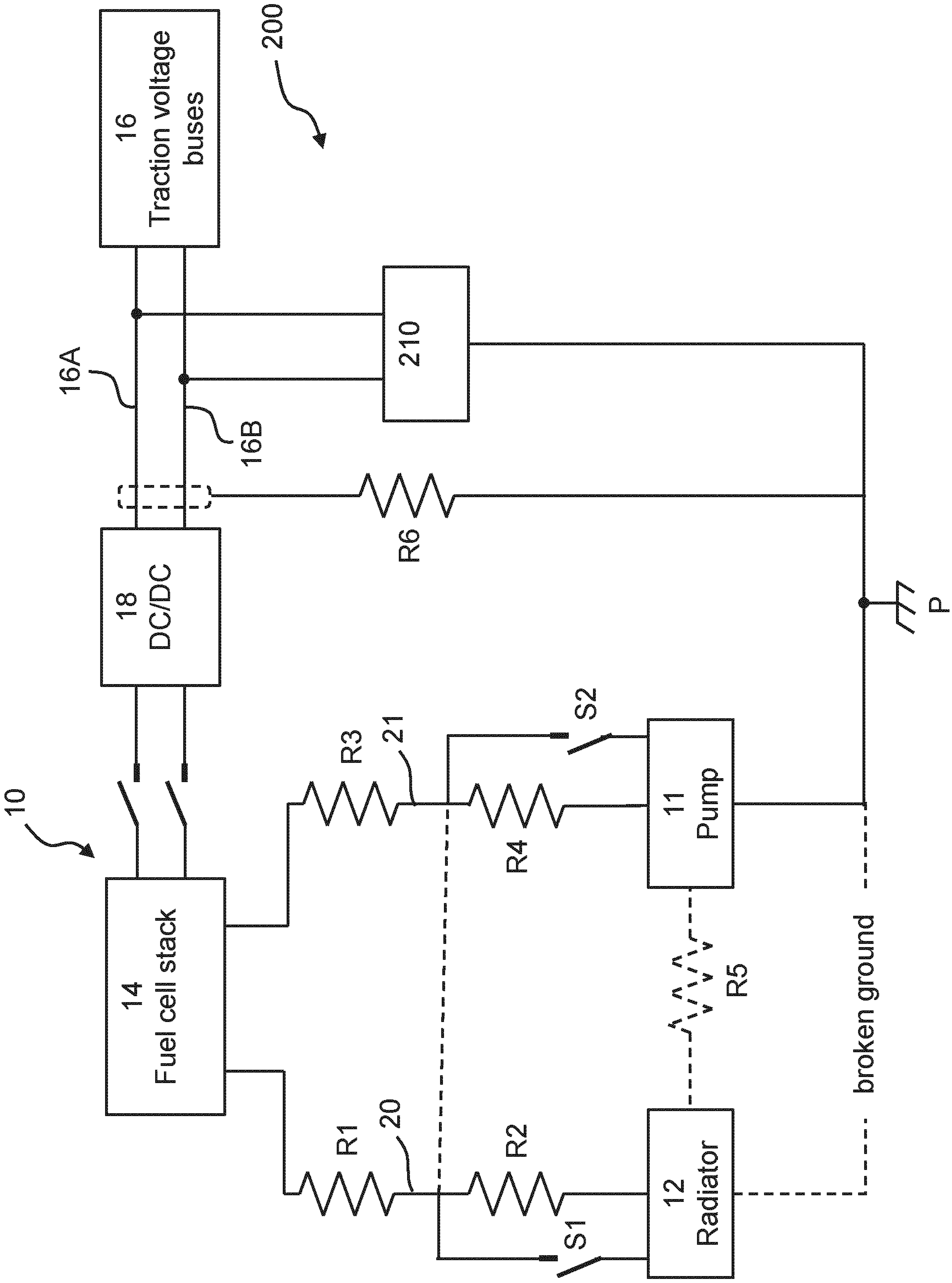
16
Traction voltage
buses
200
16A
16B
210
18
DC/DC
R6
P
10
14
Fuel cell stack
R3
21
R4
S2
11
Pump
R1
20
R2
S1
12
Radiator
R5
broken ground

FIG. 3

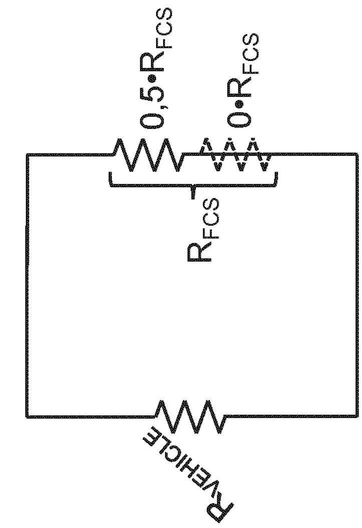


FIG. 4C

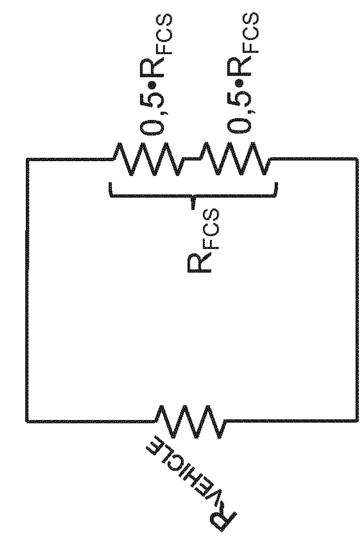


FIG. 4B

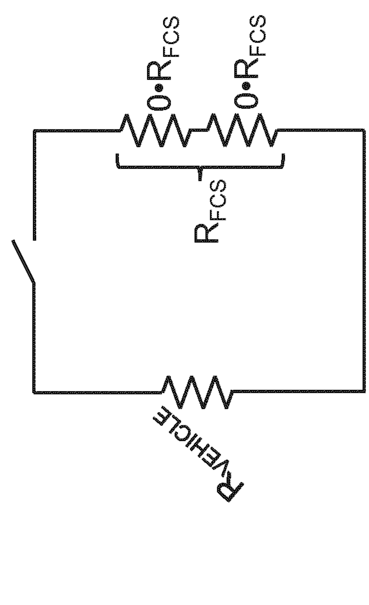


FIG. 4A

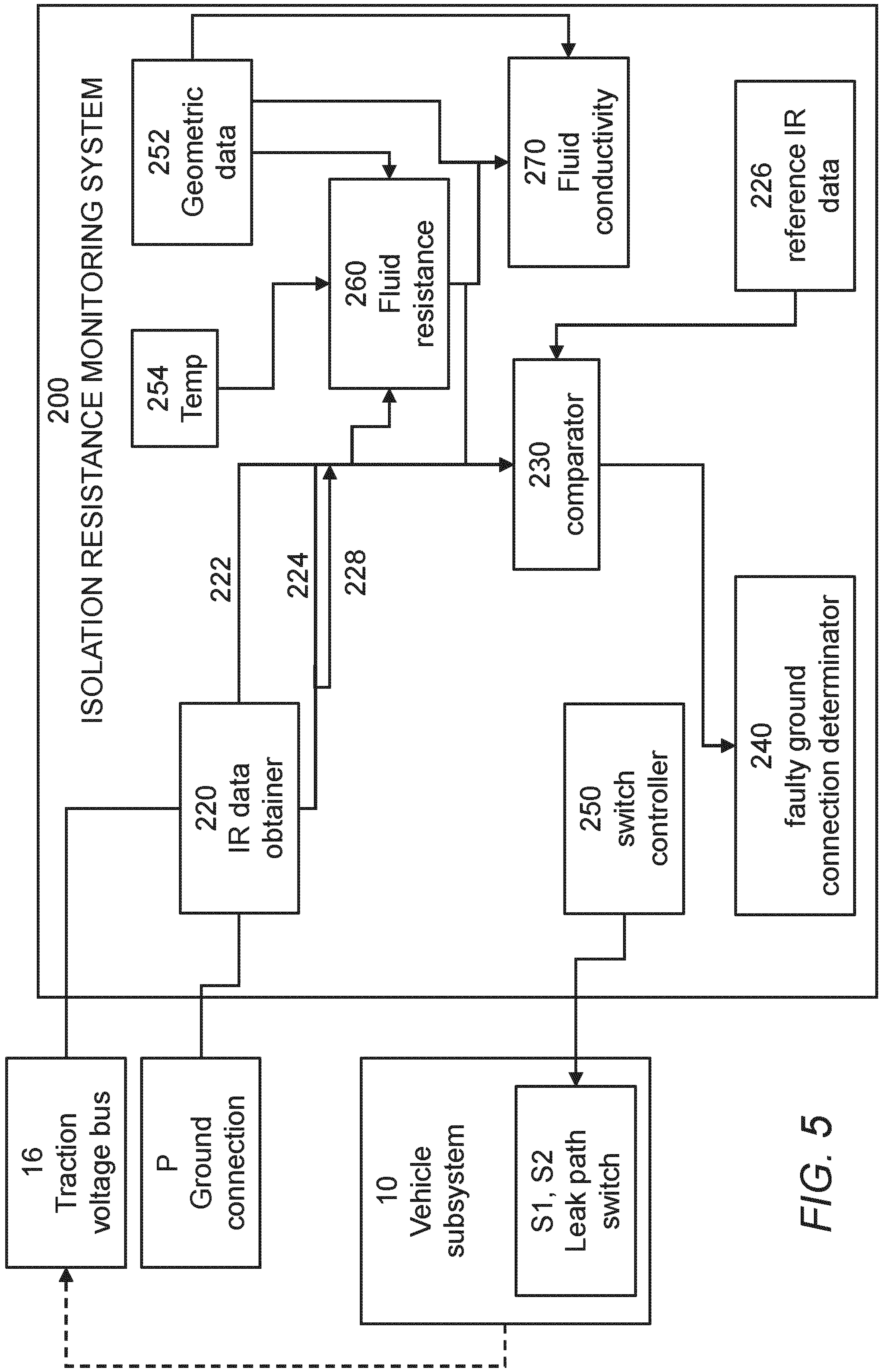
200
ISOLATION RESISTANCE MONITORING SYSTEM
252
Geometric
data
254
Temp
260
Fluid
resistance
270
Fluid
conductivity
226
reference IR
data
230
comparator
222
224
228
220
IR data
obtainer
250
switch
controller
240
faulty ground
connection determinator
16
Traction
voltage bus
P
Ground
connection
10
Vehicle
subsystem
S1, S2
Leak path
switch

FIG. 5

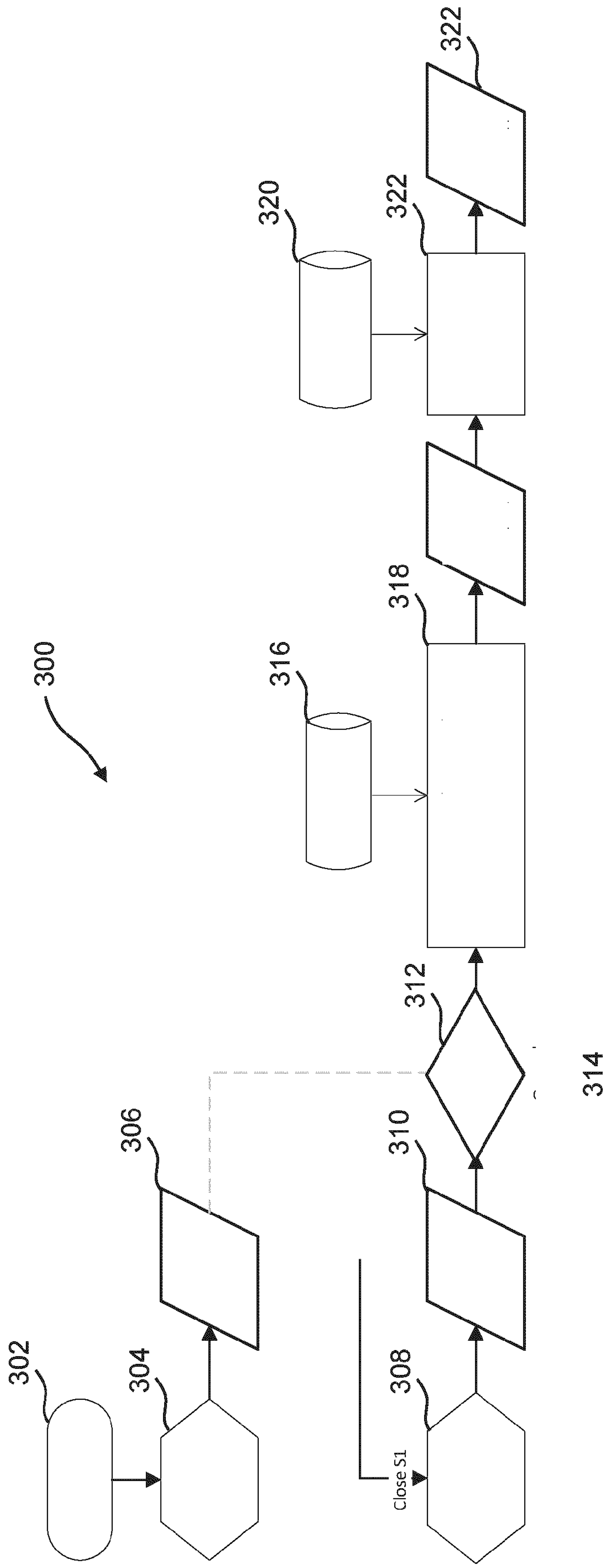


FIG. 6

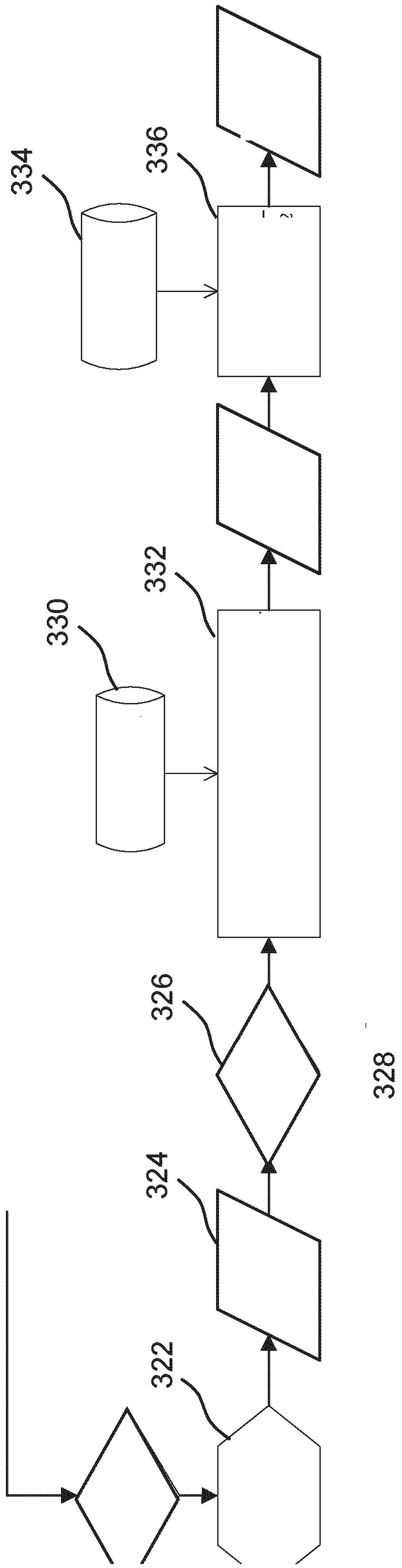


FIG. 7

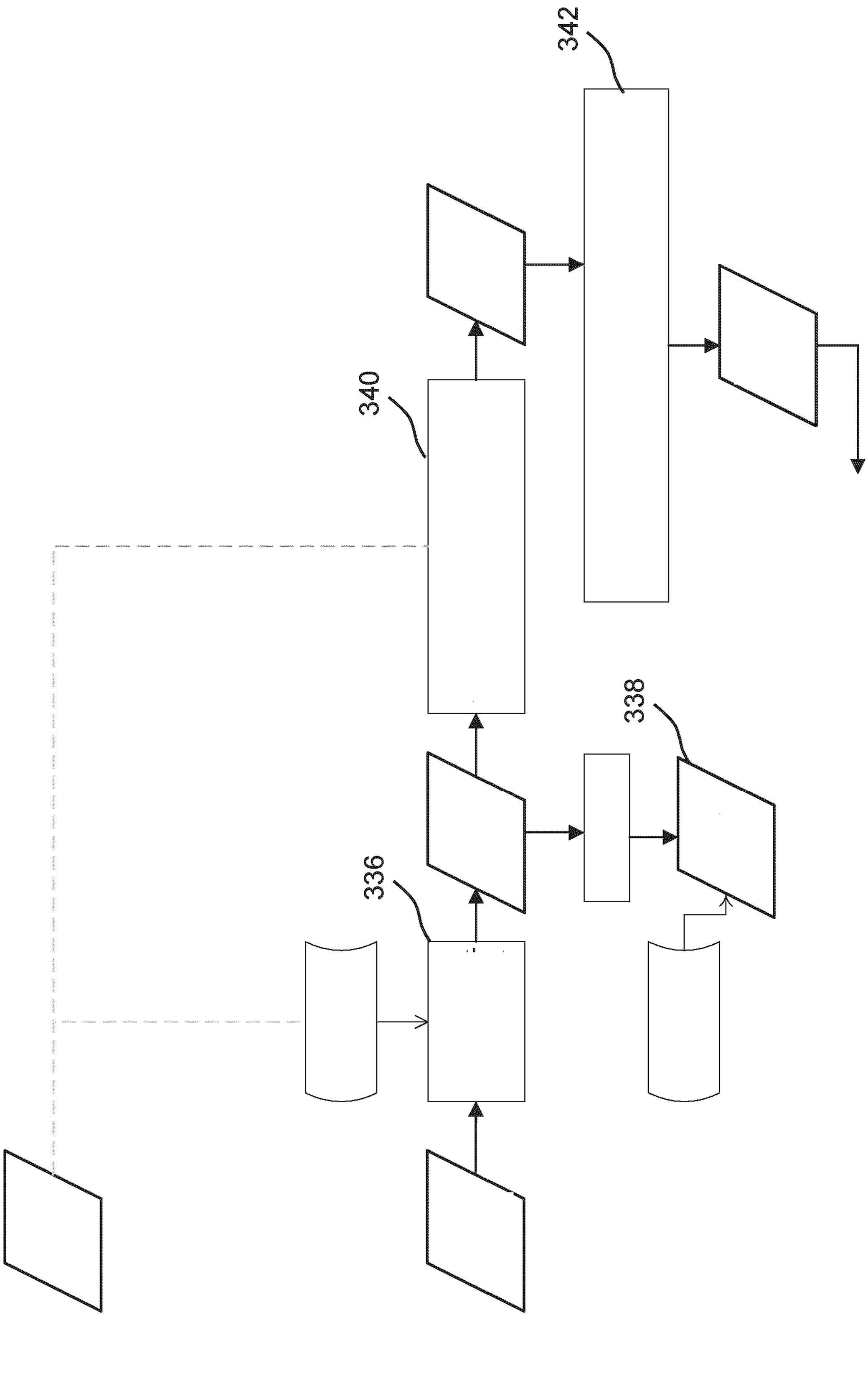


FIG. 8

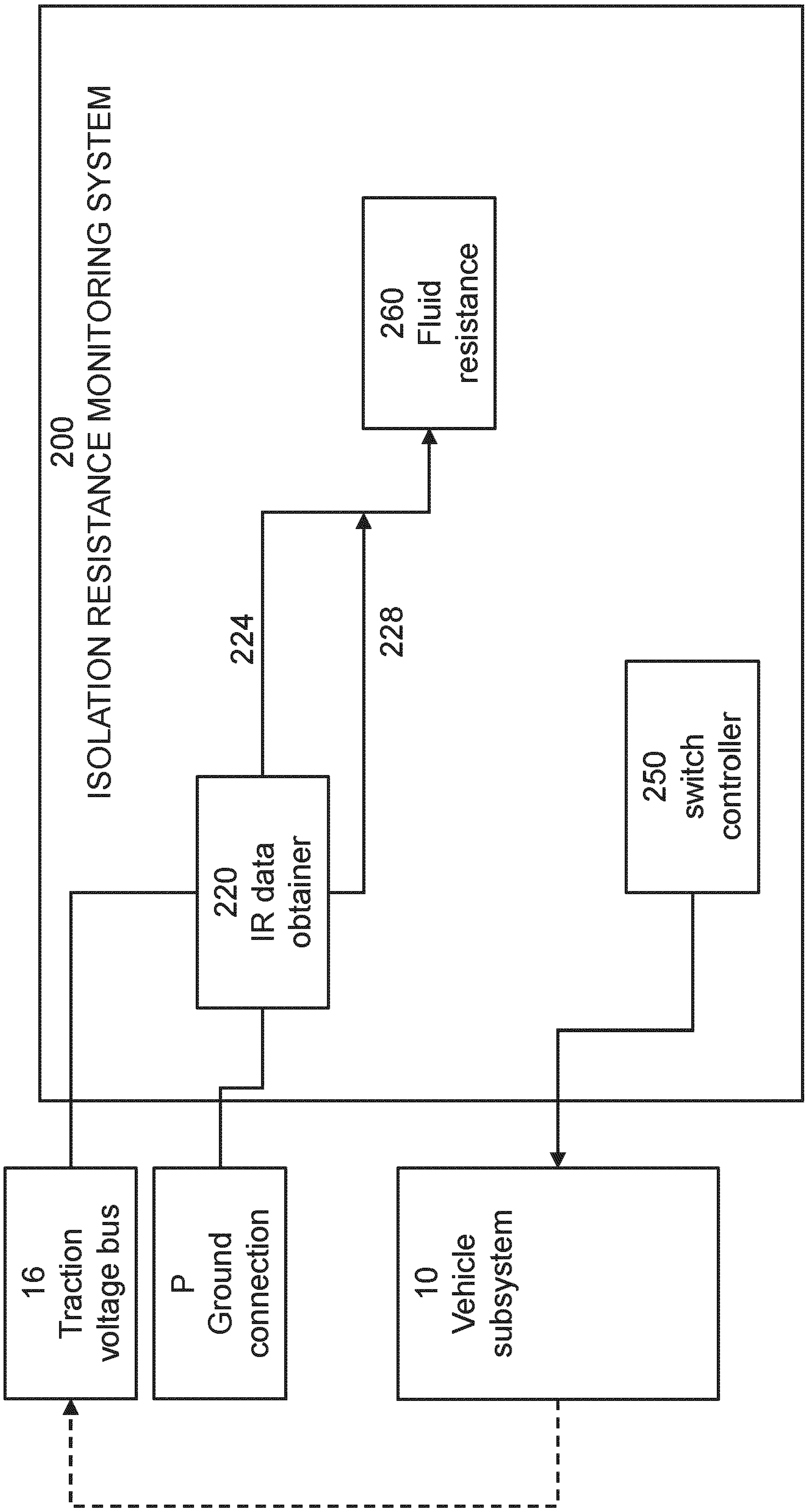
200
ISOLATION RESISTANCE MONITORING SYSTEM
260
Fluid
resistance
224
228
220
IR data
obtainer
250
switch
controller
16
Traction
voltage bus
P
Ground
connection
10
Vehicle
subsystem

FIG. 9

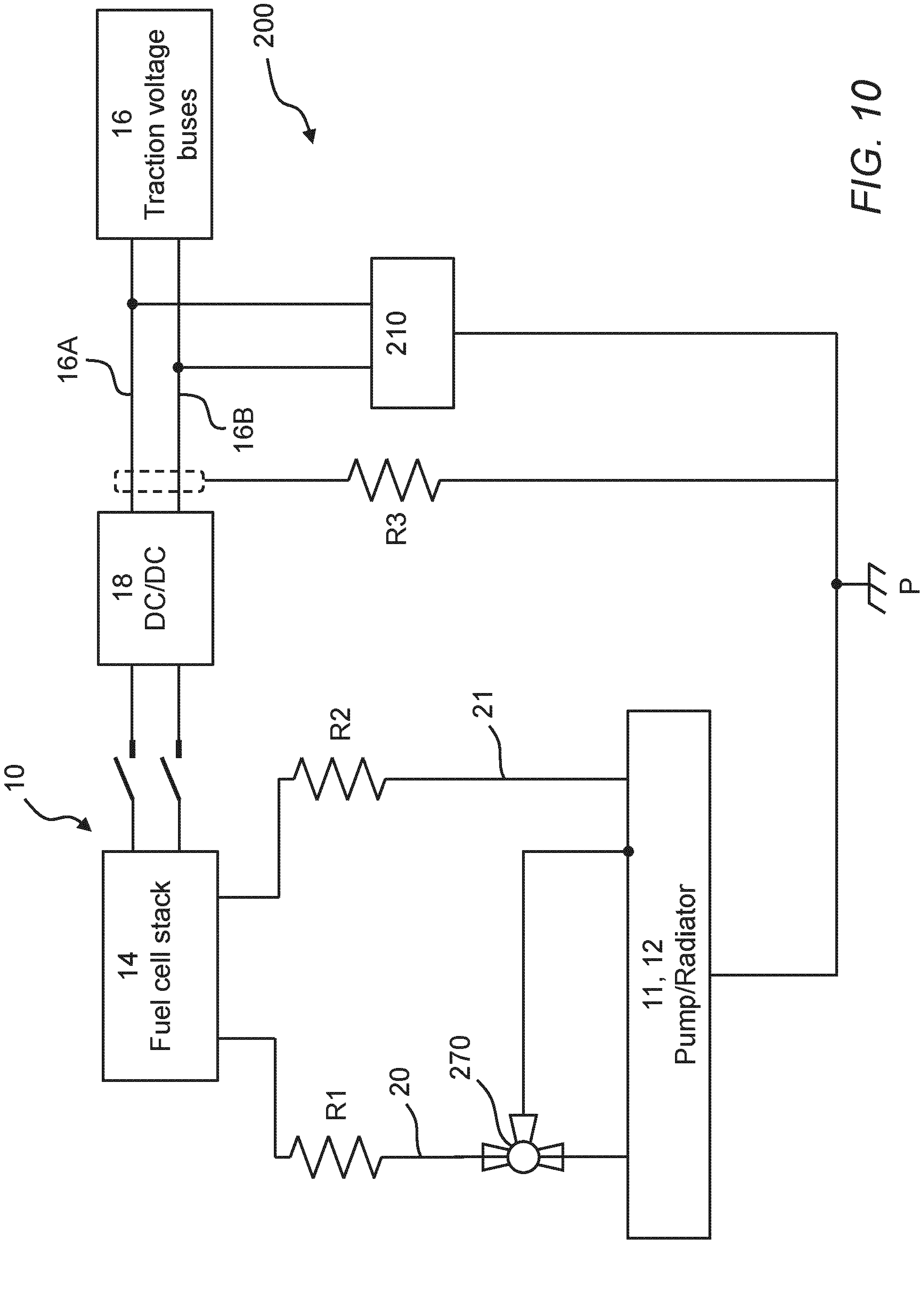
16
Traction voltage buses
200
16A
16B
210
R3
18
DC/DC
P
10
R2
21
14
Fuel cell stack
11, 12
Pump/Radiator
R1
20
270

FIG. 10

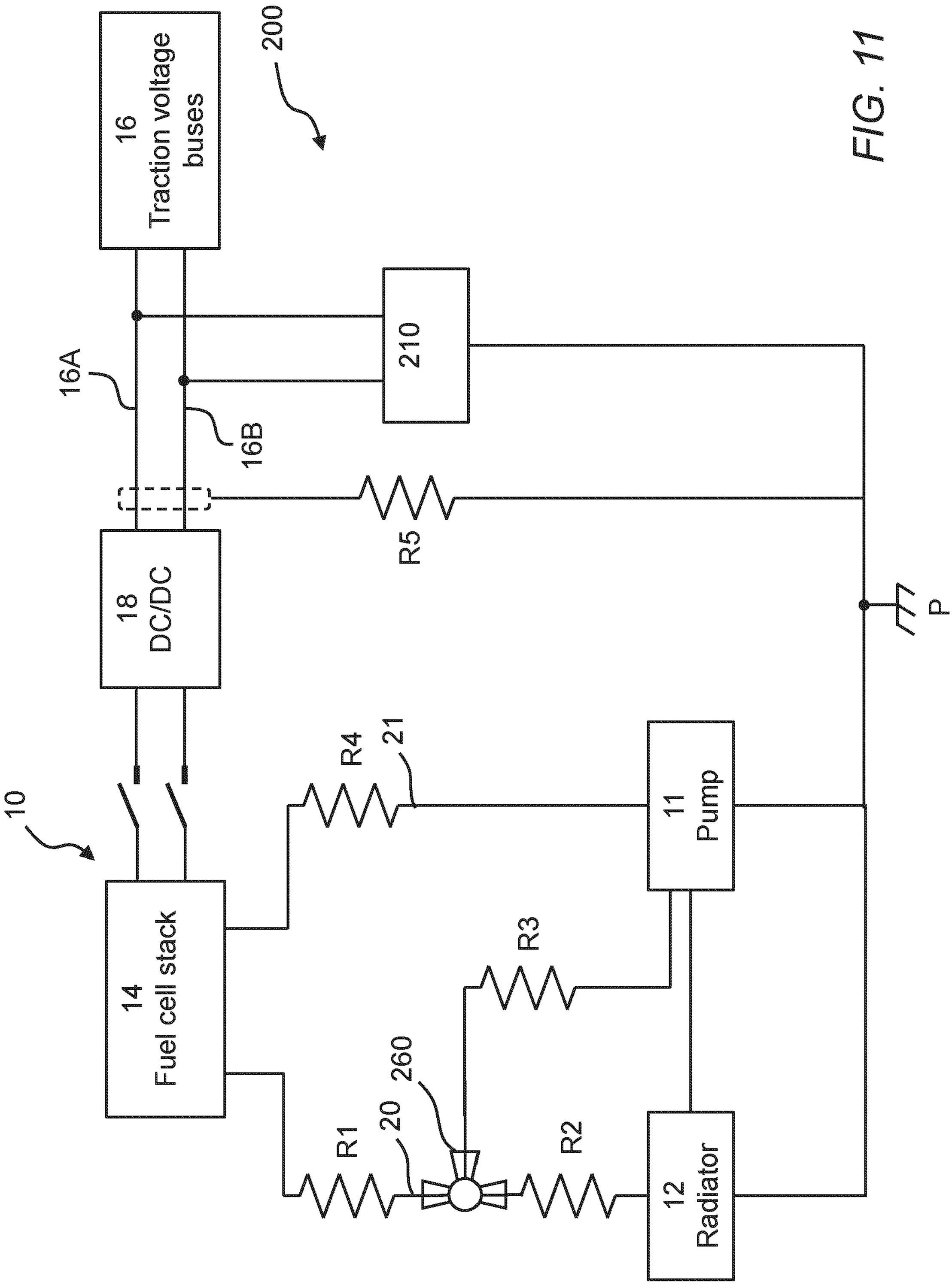
16
Traction voltage
buses
200
210
16A
16B
R5
18
DC/DC
P
10
R4
21
11
Pump
14
Fuel cell stack
R3
260
R1
20
R2
12
Radiator

FIG. 11

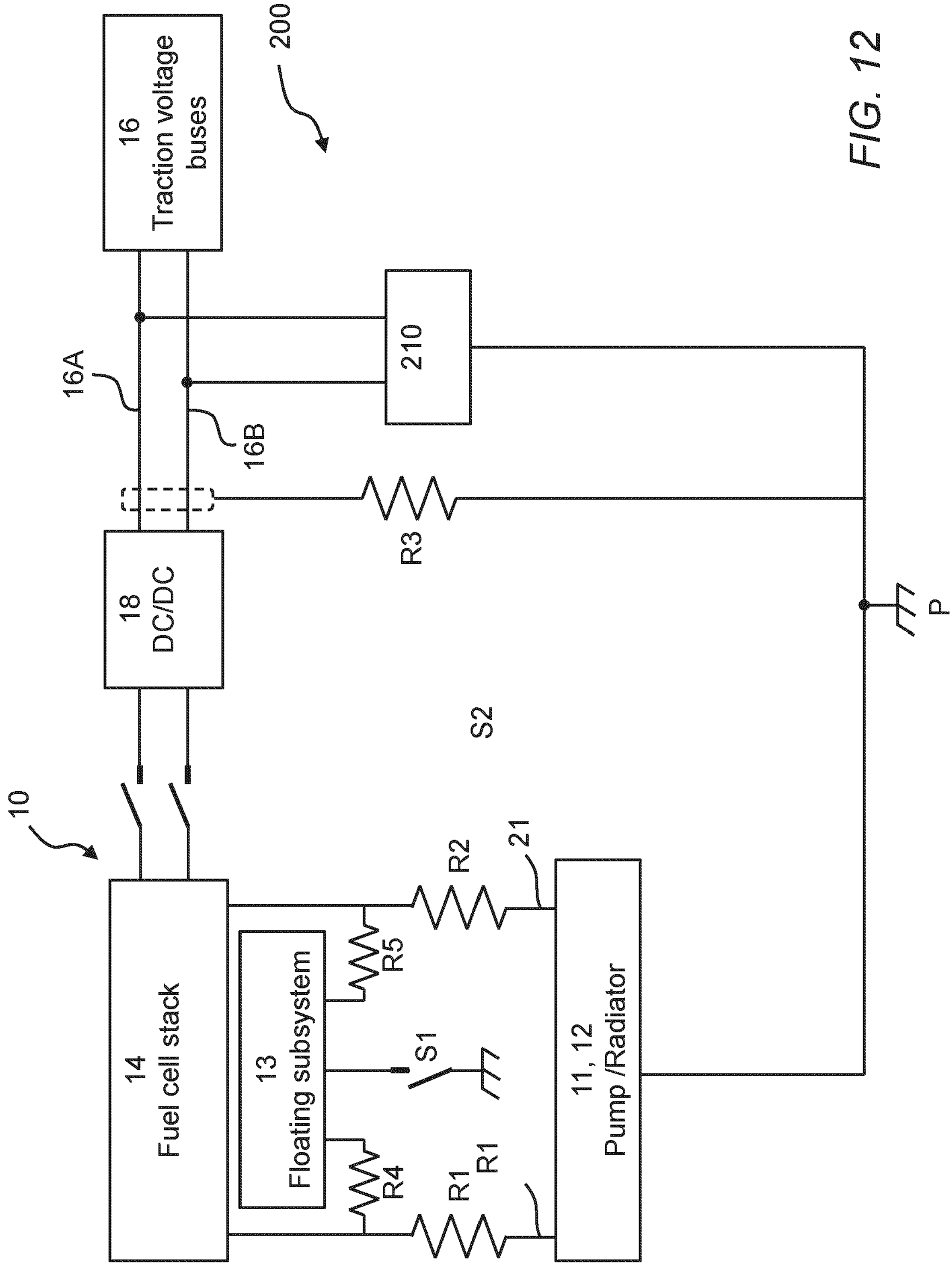
16
Traction voltage
buses
200
16A
16B
210
18
DC/DC
R3
P
S2
10
R2
21
14
Fuel cell stack
13
Floating subsystem
R5
S1
R4
R1
R1
11, 12
Pump /Radiator

FIG. 12

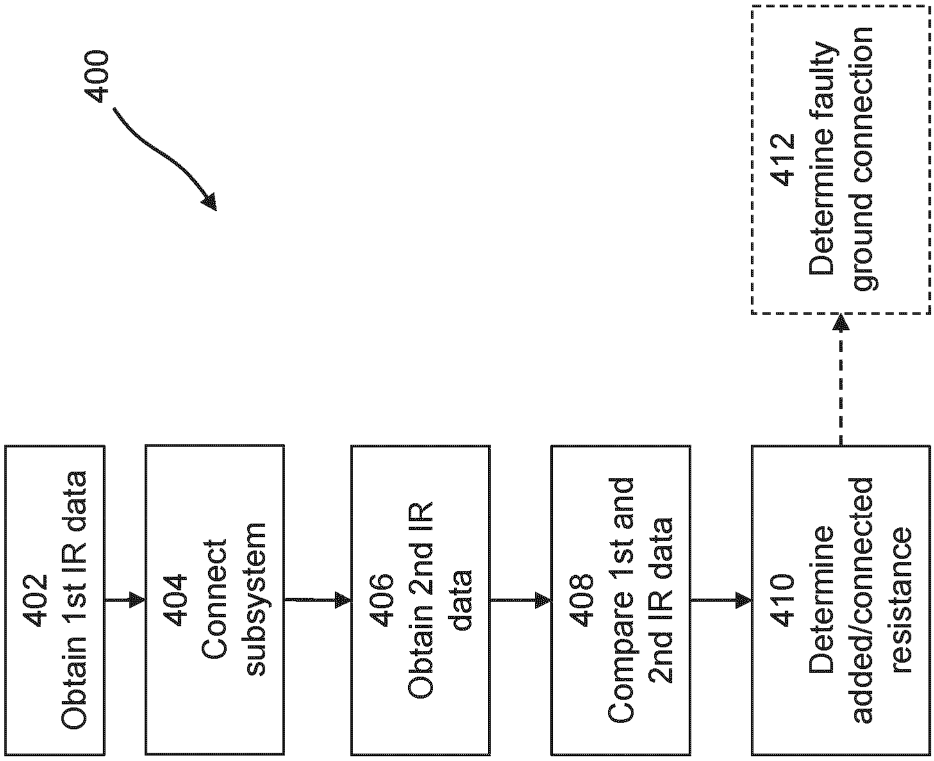
400
402
Obtain 1st IR data
404
Connect subsystem
406
Obtain 2nd IR data
408
Compare 1st and 2nd IR data
410
Determine added/connected resistance
412
Determine faulty ground connection

*FIG. 13*

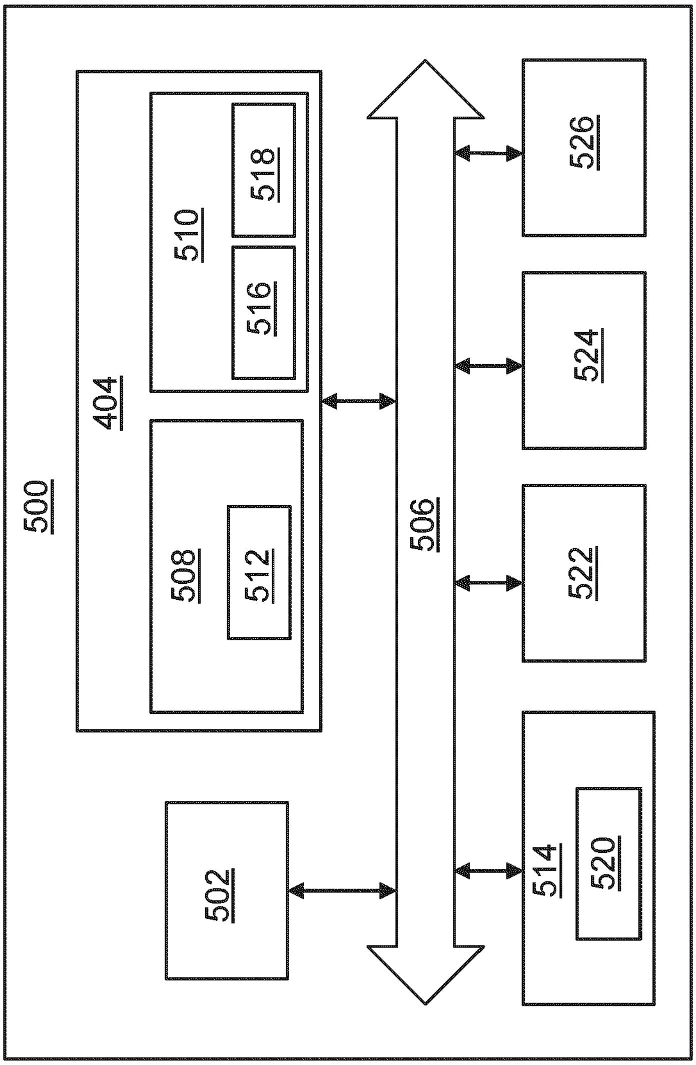


FIG. 14

Europäisches Patentamt
European Patent Office
Office européen des brevets

# EUROPEAN SEARCH REPORT

Application Number
EP 24 19 8459

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/266223 A1 (FOLEY ROBERT S [US]) 18 September 2014 (2014-09-18) | 1-7 | INV. G01R27/20 G01R27/22 G01R31/52 B60L3/00 H01M8/04858 |
| A | * figures 1-6 * * claim 1 * * paragraph [0010] - paragraph [0036] * ----- | 8-15 | |
| X | US 2017/102432 A1 (FOLEY ROBERT S [US]) 13 April 2017 (2017-04-13) | 1-7 | |
| A | * figures 1-4 * * paragraph [0010] - paragraph [0029] * ----- | 8-15 | |

TECHNICAL FIELDS SEARCHED (IPC)

G01R
B60L
H01M

The present search report has been drawn up for all claims

1

| Place of search | Date of completion of the search | Examiner |
|---|---|---|
| Munich | 4 February 2025 | Sedlmaier, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 24 19 8459

This annex lists the patent family members relating to the patent documents cited in the above-mentioned European search report. The members are as contained in the European Patent Office EDP file on
The European Patent Office is in no way liable for these particulars which are merely given for the purpose of information.

04-02-2025

| Patent document cited in search report | Publication date | Patent family member(s) | Publication date |
|---|---|---|---|
| US 2014266223 A1 | 18-09-2014 | CN 104051759 A | 17-09-2014 |
| | | DE 102014103117 A1 | 18-09-2014 |
| | | US 2014266223 A1 | 18-09-2014 |
| US 2017102432 A1 | 13-04-2017 | CN 106571480 A | 19-04-2017 |
| | | DE 102016119015 A1 | 13-04-2017 |
| | | JP 2017076607 A | 20-04-2017 |
| | | US 2017102432 A1 | 13-04-2017 |

EPO FORM P0459

For more details about this annex : see Official Journal of the European Patent Office, No. 12/82